# EUROPEAN PATENT APPLICATION

(11) **EP 1 760 771 A1**
(43) Date of publication of application: **07.03.2007**
(21) Application number: 05741630.7
(22) Date of filing: 20.05.2005
(51) Int. Cl.: H01L 21/3205, C23C 16/40, H01L 21/28, H01L 21/285, H01L 21/768

(54) **SEMICONDUCTOR DEVICE AND METHOD FOR FABRICATING THE SAME**

(30) Priority: 21.06.2004 JP 2004182692
(71) Applicant: MATSUSHITA ELECTRIC INDUSTRIAL CO., LTD., Osaka 571-8501 (JP)
(72) Inventor: AOI, Nobuo, c/o Matsushita Elec. Ind. Co., Ltd., Osaka 540-6319 (JP); NAKAGAWA, Hideo, c/o Matsushita Elec. Ind. Co., Lt, Osaka 540-6319 (JP); IKEDA, Atsushi, c/o Matsushita Elec. Ind. Co., Ltd, Osaka 540-6319 (JP)
(74) Representative: Grünecker, Kinkeldey, Stockmair & Schwanhäusser Anwaltssozietät
(86) International application number: PCT/JP2005/009269
(87) International publication number: WO 2005/124847

(57) **Abstract**

A semiconductor device includes insulation films **(6** and **8)** formed over a silicon substrate **(1),** a buried wire **(14)** formed in the insulation films **(6** and **8),** and a barrier metal film **(A1)** formed between each of the insulation films (**6** and **8**) and the buried wire **(14).** The barrier metal film **(A1)** is formed of a metal oxide film **(11),** a transition layer **(12a)** and a metal film **(13)** stacked in this order in the direction from a side of the barrier metal film **(A1)** at which the insulation films **(6** and **8)** exists to a side thereof at which the buried wire **(14)** exists. The transition layer **(12a)** is formed of a single atomic layer having substantially an intermediate composition between respective compositions of the metal oxide film **(11)** and the metal film **(13).**

## Description

### TECHNICAL FIELD

The present invention relates to a semiconductor device including a metal wire and a method for fabricating the semiconductor device, and more particularly relates to a barrier metal film and a method for forming the barrier metal film.

### BACKGROUND ART

In recent years, as the feature size of semiconductor integrated circuit devices (which will be hereafter referred to as "semiconductor devices") becomes smaller, a combination of a copper wire and an insulation film having a low dielectric constant, i.e., a so-called low-k film has been adopted as a multi-layer wire of a semiconductor device. With use of such a multi-layer wire, RC delay and power consumption can be reduced. Furthermore, to increase the degree of integration, function and operation speed of a semiconductor device, use of a low-k film having an even lower dielectric constant than that of those presently used is examined.

A copper wire is usually formed using a damascene technique. Damascene techniques include a single damascene technique in which a wire and a via plug are alternately formed and a dual damascene technique in which a wire and a via plug are simultaneously formed.

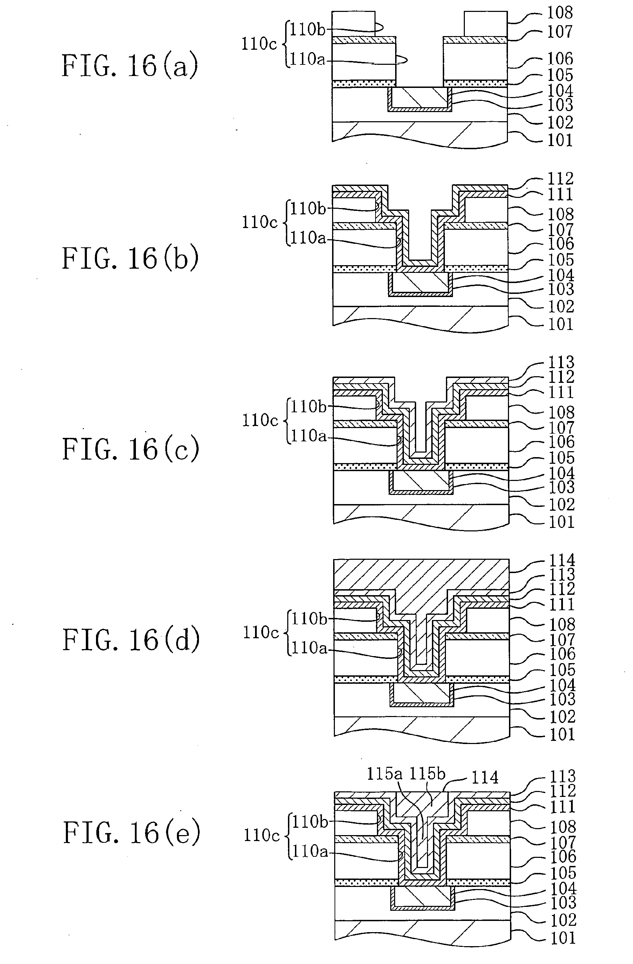

Hereinafter, a method for forming a multi-layer wire by a damascene technique will be described with reference to FIGS. **16(a)** and **16(b).**

As shown in FIG. **16(a),** a first insulation film **102** is formed on a silicon substrate **101** and then a first copper wire **104** formed of copper and including a first barrier metal film **103** is formed in the first insulation film **102.** On the silicon substrate **101,** a transistor and the like (not shown) are formed. Subsequently, a dielectric barrier film **105** for preventing diffusion of copper, a second insulation film **106,** a third insulation film **107** and a fourth insulation film **108** are formed in this order over the first insulation film **102** and the first copper wire **104.**

As the dielectric barrier film **105,** a silicon nitride film, a silicon nitride carbide film, a silicon carbide oxide film or the like is used. The dielectric barrier film **105** has the function of preventing diffusion of copper of the first insulation film **104** into the second insulation film **106** and the fourth insulation film **108.** The same material as that of dielectric barrier film **105** is used for the third insulation film **107.**

Moreover, a silicon oxide film, a fluorine-doped silicon oxide film, a silicon oxide carbide film or an insulation film formed of an organic film is used for the second insulation film **106** and the fourth insulation film **108.** Each of these insulation films may be a film formed by chemical vapor deposition or may be a SOD (spin on dielectric) film formed by spin coating.

Next, a via hole **110a** is formed in the dielectric barrier film **105,** the second insulation film **106** and the third insulation film **107,** and a wiring groove **110b** is formed in the fourth insulation film **108.** Thus, as shown in FIG. **16(a),** a recess portion **110c** including the via hole **110a** and the wiring groove **110b** is obtained. The via hole **110a** and the wiring groove **110b** are preferably formed by the process step of forming a dual damascene wiring groove (i.e., the recess portion **110c** including the via hole **110a** and the wiring groove **110b)** using known lithography, etching, ashing and cleaning. In general, a method in which the via hole **110a** is first formed and then the wiring groove (trench) **110b** is formed has been widely used (for example, see Patent Reference 1).

Next, as shown in FIG. **16(b),** a second barrier metal film **111** and a third barrier metal film **112** are formed by physical vapor deposition (PVD) to cover surfaces of the recess portion **110c.**

Next, as shown in FIG. **16(c),** a copper seed layer **113** is formed on the third barrier metal film **112** by physical vapor deposition.

Next, as shown in FIG. **16(d),** a copper film **114** is formed by copper electroplating using the copper seed layer **113** so as to fill the recess portion **110c** and entirely cover surfaces of the third barrier metal film **112.**

Next, as shown in FIG. **16(e),** part of the copper film **114** located on the fourth insulation film **108,** except for part thereof located inside of the recess portion **110c,** and parts of the second barrier metal film **111** and the third barrier metal film **112** located on the fourth insulation film **108,** except for parts thereof located inside of the recess portion **110c** is removed by polishing using chemical mechanical polishing (CMP). Thus, a via plug **115a** and a second wire **115b** are formed. Note that only one of the via plug **115a** and the second wire **115b** may be provided. A multi-layer wire can be formed by repeating a series of process steps described above.

In general, copper is easily diffused in an insulation film such as silicon oxide film by heat or an electric field. This tends to be a cause of deterioration of transistor characteristics. Also, copper has poor adhesion with an insulation film. Therefore, a method in which in forming a copper wire, a barrier metal film of a tantalum film or a tantalum nitride film is formed between copper and an insulation film to prevent diffusion of copper into an insulation film and improve adhesion between the insulation film and copper has been proposed (for example, see Patent Reference 2). A tantalum film or a tantalum nitride film is used as a single layer or a lamination structure.

However, when a refractory metal such as tantalum is used as the second barrier metal film **111** formed to be in contact with each of the second, third and fourth insulation films **106, 107** and **108,** the problem of poor adhesion between the second barrier metal film **111** formed of a refractory metal and each of the second, third and fourth insulation films **106, 107** and **108** forming the recess portion **110c** which is a damascene wire arises. To cope with this problem, a tantalum nitride film is used as the second barrier metal film **111** and a tantalum film is used as the third barrier metal film **112,** thereby improving such poor adhesion. However, sufficient adhesion is not achieved.

Moreover, when a tantalum film is formed as the third barrier metal film **112,** the tantalum film is oxidized in forming copper by electroplating. Thus, a high resistance tantalum oxide film is formed. Therefore, increase in wire resistance can not be avoided.

Moreover, when a tantalum nitride film is used as the third barrier metal film **112,** the tantalum nitride film is not oxidized. However, a tantalum nitride film itself has a high resistance and adhesion thereof with copper is low.

Furthermore, when a titanium film or a titanium nitride film is used as the third barrier metal film **112,** the same problem arises as when a tantalum film or a tantalum nitride film is used. Therefore, a metal such as ruthenium and iridium which itself or whose oxide has a low resistance is used as the third barrier metal film **112** to achieve reduction in resistance of the third barrier metal film **112** (see, for example, Patent Reference 3 and Patent Reference 4) and this technique has attracted interest. In general, such metals are formed by atomic layer deposition or chemical vapor deposition.
(Patent Reference 1) Japanese Laid-Open Publication No. 10-223755
(Patent Reference 2) Japanese Laid-Open Publication No. 2002-43419
(Patent Reference 3) Japanese Patent Publication No. 3409831
(Patent Reference 4) Japanese Laid-Open Publication No. 2002-75994

### DISCLOSURE OF INVENTION

### Problems that the invention is to solve

However, when a refractory metal film such as tantalum and ruthenium is used as a barrier metal film, adhesion between an insulation film in which a recess portion for a damascene wire is formed and the barrier metal film of the refractory metal film becomes poor. Although such poor adhesion can be improved by forming a metal nitride film between the barrier metal film of a refractory metal film and the insulation film, compared to the case where the barrier metal film of a refractory metal is formed directly on the insulation film, a resistance is increased.

In view of the above-described problems, it is an object of the present invention to provide a semiconductor device including a barrier metal film with a low resistance and excellent adhesion with each of an insulation film and a wire and a method for fabricating the semiconductor device.

### Means of solving the problems

To achieve the above-described object, a first semiconductor device according to the present invention is characterized in that the semiconductor device includes: an insulation film formed on a substrate; a buried wire formed in the insulation film; and a barrier metal film formed between the insulation film and the buried wire, and the barrier metal film is formed of a metal oxide film, a transition layer and a metal film stacked in this order in the direction from a side of the barrier metal film at which the insulation film exists to a side thereof at which the buried wire exists, and the transition layer is formed of a single atomic layer having substantially an intermediate composition between respective compositions of the metal oxide film and the metal film.

In the first semiconductor device of the present invention, the transition layer having substantially the intermediate composition between the respective compositions of the metal oxide film and the metal film exists at an interface between the metal oxide film and the metal film. Thus, compared to the case where the transition layer does not exist at the interface between the metal oxide film and the metal film, adhesion between the metal oxide film and the metal film is remarkably improved. Furthermore, since the transition layer is formed of a single atomic layer, in addition to improvement of adhesion between the metal oxide film and the metal film, a barrier metal film can be formed so as to have a small thickness by reducing the thickness of the transition layer to an absolute minimum even when the barrier metal film has a lamination structure, so that a resistance of a wire can be reduced. Therefore, a highly reliable semiconductor device including a multi-layer wire with a low resistance and excellent adhesion can be achieved.

A second semiconductor device according to the present invention is characterized in that the semiconductor device includes: an insulation film formed on a substrate; a buried wire formed in the insulation film; and a barrier metal film formed between the insulation film and the buried wire, the barrier metal film is formed of a metal oxide film, a transition layer and a metal film stacked in this order in the direction from a side of the barrier metal film at which the insulation film exists to a side thereof at which the buried wire exists, and the transition layer is formed of a plurality of atomic layers having substantially an intermediate composition between respective compositions of the metal oxide film and the metal film.

In the second semiconductor device of the present invention, the transition layer having substantially the intermediate composition between the respective compositions of the metal oxide film and the metal film exists at an interface between the metal oxide film and the metal film. Thus, compared to the case where the transition layer does not exist at the interface between the metal oxide film and the metal film, adhesion between the metal oxide film and the metal film is remarkably improved. Accordingly, a barrier metal film having a small thickness and excellent adhesion can be formed. Furthermore, since the transition layer is formed of a plurality of atomic layers, adhesion is further improved, compared to the case where the transition layer provided between the metal oxide film and the metal film is formed of a single atomic layer. Moreover, the composition of the transition layer varies stepwise, so that adhesion is further improved. Therefore, a highly reliable semiconductor device including a multi-layer wire with a low resistance and excellent adhesion can be achieved.

In each of the first and second semiconductor devices of the present invention, it is preferable that a metal forming the metal oxide film and a metal forming the metal film are different elements.

Thus, in a layer structure of a metal film/ a transition layer/ a metal oxide film/ an insulation film, adhesion between the insulation film and the metal oxide film can be optimized according to a kind of the insulation film without degrading adhesion between the metal oxide film and the metal film. Therefore, a highly reliable semiconductor device including a multi-layer wire with a low cost and excellent adhesion can be achieved.

In each of the first and second semiconductor devices of the present invention, it is preferable that a metal forming the metal oxide film and a metal forming the metal film are the same element.

Thus, in a layer structure of a metal film/ a transition layer/ a metal oxide film, adhesion at an interface between the transition layer and the metal film and at an interface between the metal oxide film and the transition layer can be improved. Therefore, a highly reliable semiconductor device including a multi-layer wire with a low resistance and excellent adhesion can be achieved.

A third semiconductor device according to the present invention is characterized in that the semiconductor device includes: an insulation film formed on a substrate; a buried wire formed in the insulation film; and a barrier metal film formed between the insulation film and the buried wire, the barrier metal film is formed of a transition layer and a metal film stacked in this order in the direction from a side of the barrier metal film at which the insulation film exists to a side thereof at which the buried wire exists, and the transition layer is formed of a single atomic layer including a metal oxide and a metal forming the metal film and having substantially an intermediate composition between respective compositions of the metal oxide and the metal film.

In the third semiconductor device of the present invention, the transition layer having substantially the intermediate composition between the respective compositions of the metal oxide and the metal film exists at an interface between the insulation film and the metal film. Thus, compared to the case where the transition layer does not exist at the interface between the insulation film and the metal film, adhesion between the insulation film and the metal film can be remarkably improved. Furthermore, since the transition layer is formed of a single atomic layer, in addition to improvement of adhesion between the insulation film and the metal film, a barrier metal film can be formed so as to have a small thickness, even when the barrier metal film has a lamination structure, by reducing the thickness of the transition layer to an absolute minimum, so that a resistance of a wire can be reduced. Therefore, a highly reliable semiconductor device including a multi-layer wire with a low resistance and excellent adhesion can be achieved.

A fourth semiconductor device according to the present invention is characterized in that the semiconductor device includes: an insulation film formed on a substrate; a buried wire formed in the insulation film; and a barrier metal film formed between the insulation film and the buried wire, the barrier metal film is formed of a transition layer and a metal film stacked in this order in the direction from a side of the barrier metal film at which the insulation film exists to a side thereof at which the buried wire exists, and the transition layer is formed of a plurality of atomic layers including metal oxide and a metal forming the metal film and having substantially an intermediate composition between respective compositions of the metal oxide and the metal film.

In the fourth semiconductor device of the present invention, the transition layer having substantially the intermediate composition between the respective compositions of the metal oxide and the metal film exists at an interface between the insulation film and the metal film. Thus, compared to the case where the transition layer does not exist at the interface between the insulation film and the metal film, adhesion between the insulation film and the metal film can be remarkably improved. Accordingly, a barrier metal film having a small thickness and excellent adhesion can be formed. Furthermore, as another effect, the transition layer is formed of a plurality of atomic layers, so that adhesion is further improved, compared to the case where the transition layer provided between the insulation film and the metal film is formed of a single atomic layer. Moreover, the composition of the transition layer varies stepwise, so that adhesion is further improved. Therefore, a highly reliable semiconductor device including a multi-layer wire with a low resistance and excellent adhesion can be achieved.

In each of the third and fourth semiconductor devices of the present invention, it is preferable that a metal forming the metal oxide and a metal forming the metal film are different elements.

Thus, in a layer structure of a metal film/ a transition layer/ an insulation film, adhesion between the insulation film and the transition layer can be optimized according to a kind of the insulation film without degrading adhesion between the transition layer and the metal film. Therefore, a highly reliable semiconductor device including a multi-layer wire with a low resistance and excellent adhesion can be achieved.

In each of the third and fourth semiconductor devices of the present invention, it is preferable that a metal forming the metal oxide and a metal forming the metal film are the same element.

Thus, in a layer structure of a metal film/ a transition layer, adhesion at an interface between the transition layer and the metal film can be improved. Therefore, a highly reliable semiconductor device including a multi-layer wire with a low resistance and excellent adhesion can be achieved.

A fifth semiconductor device according to the present invention is characterized in that the semiconductor device includes: an insulation film formed on a substrate; a buried wire formed in the insulation film; and a barrier metal film formed between the insulation film and the buried wire, the barrier metal film contains oxygen as a component element, and a concentration of oxygen contained in the barrier metal film continuously varies in a film thickness direction of the barrier metal film.

In the fifth semiconductor device of the present invention, an oxygen concentration in the barrier metal film containing oxygen as a component element continuously varies in a film thickness direction from a surface of the barrier metal film which is in contact with the insulation film to a surface thereof which is in contact with the buried wire. Thus, the barrier metal film does not have an interface at which a composition is remarkably changed, so that the strength of the second barrier metal film itself can be largely improved. Thus, a highly reliable semiconductor device including a multi-layer wire with a low resistance and excellent adhesion can be achieved.

A method for fabricating a first semiconductor device according to the present invention is characterized in that the method includes the steps of: forming a recess portion in an insulation film provided on a substrate; forming a barrier metal film including a metal oxide film, a transition layer and a metal film stacked in this order so that the barrier metal film covers surfaces of the recess portion; and forming a buried wire on the barrier metal film so that the recess portion is filled, and the step of forming the barrier metal film includes the step of performing a single cycle of deposition by atomic layer deposition, thereby forming the transition layer of a single atomic layer having substantially an intermediate composition between respective compositions of the metal oxide film and the metal film.

According to the first semiconductor fabrication method of the present invention, a transition layer of a single atomic layer having substantially an intermediate composition between respective compositions of a metal oxide film and a metal film can be formed at an interface between the metal oxide film and the metal film in a simple manner. Thus, compared to the case where the transition layer does not exist at the interface between the metal oxide film and the metal film, adhesion between the metal oxide film and the metal film can be remarkably improved. Furthermore, since the transition layer is formed of a single atomic layer, in addition to improvement of adhesion between the metal oxide film and the metal film, a barrier metal film can be formed so as to have a small thickness, even when the barrier metal film has a lamination structure, by reducing the thickness of the transition layer to an absolute minimum, so that a resistance of a wire can be reduced. Therefore, a highly reliable semiconductor device including a multi-layer wire with a low resistance and excellent adhesion can be fabricated.

A second method for fabricating a semiconductor device according to the present invention is characterized in that the method includes the steps of: forming a recess portion in an insulation film provided on a substrate; forming a barrier metal film including a metal oxide film, a transition layer and a metal film stacked in this order so that the barrier metal film covers surfaces of the recess portion; and forming a buried wire on the barrier metal film so that the recess portion is filled, the step of forming the barrier metal film includes the step of performing a plurality of cycles of deposition by atomic layer deposition, thereby forming the transition layer including a plurality of atomic layers having substantially an intermediate composition between respective compositions of the metal oxide film and the metal film.

According to the second semiconductor device fabrication method according to the present invention, a transition layer of a plurality of atomic layers having substantially an intermediate composition between respective compositions of a metal oxide film and a metal film can be formed in a simple manner. Thus, compared to the case where the transition layer does not exist at an interface between the metal oxide film and the metal film, adhesion between the metal oxide film and the metal film is remarkably improved. Accordingly, a barrier metal film having a small thickness and excellent adhesion can be formed. Furthermore, as another effect, the transition layer is formed of a plurality of atomic layers, so that adhesion is further improved, compared to the case where the transition layer provided between the insulation film and the metal film is formed of a single atomic layer. Moreover, for example, by changing film formation conditions or a source gas stepwise in each cycle of a plurality of cycles of deposition by atomic layer deposition, the composition of the transition layer can be made to vary stepwise. Accordingly, adhesion can be further improved. Therefore, a highly reliable semiconductor device including a multi-layer wire with a low resistance and excellent adhesion can be fabricated.

In each of the first and second semiconductor fabrication methods of the present invention, it is preferable that a metal forming the metal oxide film and a metal forming the metal film are different elements.

Thus, a metal oxide film, a transition layer and a metal film can be continuously formed, for example, only by changing film formation conditions or a source gas. Accordingly, a barrier metal film having excellent adhesion can be formed, so that the first or second semiconductor device of the present invention can be fabricated in a simple manner.

In each of the first and second semiconductor fabrication methods of the present invention, it is preferable that a metal forming the metal oxide film and a metal forming the metal film are the same element.

Thus, a metal oxide film, a transition layer and a metal film can be continuously formed, for example, only by changing film formation conditions. Thus, a barrier metal film having excellent adhesion can be formed, so that the first or second semiconductor device of the present invention can be fabricated in a simple manner.

A third method for fabricating a semiconductor device according to the present invention is characterized in that the method includes the steps of: forming a recess portion in an insulation film provided on a substrate; forming a barrier metal film including a transition layer and a metal film stacked in this order so that the barrier metal film covers surfaces of the recess portion; and forming a buried wire on the barrier metal film so that the recess portion is filled, the step of forming the barrier metal film includes the step of performing a single cycle of deposition by atomic layer deposition, thereby forming the transition layer made of a single atomic layer including a metal oxide and a metal forming the metal film and having substantially an intermediate composition between respective compositions of the metal oxide and the metal film.

According to the third semiconductor fabrication method of the present invention, a transition layer having substantially an intermediate composition between respective compositions of metal oxide and a metal can be formed at an interface between the insulation film and the metal film in a simple manner. Thus, compared to the case where the transition layer does not exist at the interface between the insulation film and the metal film, adhesion between the insulation film and the metal film is remarkably improved. Furthermore, since the transition layer is formed of a single atomic layer, in addition to improvement of adhesion between the insulation film and the metal film, a barrier metal film can be formed so as to have a small thickness, even when the barrier metal film has a lamination structure, by reducing the thickness of the transition layer to an absolute minimum, so that a resistance of a wire can be reduced. Therefore, a highly reliable semiconductor device including a multi-layer wire with a low resistance and excellent adhesion can be fabricated.

A fourth method for fabricating a semiconductor device according to the present invention is characterized in that the method includes the steps of: forming a recess portion in an insulation film provided on a substrate; forming a barrier metal film including a transition layer and a metal film stacked in this order so that the barrier metal film covers surfaces of the recess portion; and forming a buried wire on the barrier metal film so that the recess portion is filled, the step of forming the barrier metal film includes the step of performing a plurality of cycles of deposition by atomic layer deposition, thereby forming the transition layer including a plurality of atomic layers made of a metal oxide and a metal forming the metal film and having an intermediate composition between respective compositions of the metal oxide and the metal film.

According to the fourth semiconductor device fabrication method of the present invention, a transistor layer formed of a plurality of atomic layers and having substantially an intermediate composition between respective compositions of a metal oxide and a metal film can be formed at an interface between the insulation film and the metal film in a simple manner. Thus, compared to the case where the transition layer does not exist in the interface between the insulation film and the metal film, adhesion between the insulation film and the metal film is remarkably improved. Accordingly, a barrier metal film having a small thickness and excellent adhesion can be formed. Furthermore, as another effect, since the transition layer is formed of a plurality of atomic layers, adhesion is further improved, compared to the case where the transition layer provided between the insulation film and the metal film is formed of a single atomic layer. Moreover, for example, by changing film formation conditions or a source gas stepwise in each cycle of a plurality of cycles of deposition by atomic layer deposition, the composition of the transition layer can be made to vary stepwise. Accordingly, adhesion can be further improved. Therefore, a highly reliable semiconductor device including a multi-layer wire with a low resistance and excellent adhesion can be fabricated.

In each of the third and fourth semiconductor device fabrication methods of the present invention, it is preferable that a metal forming the metal oxide and a metal forming the metal film are different elements.

Thus, a transition layer and a metal film can be continuously formed, for example, only by changing film formation conditions and a source gas. Accordingly, a barrier metal film having excellent adhesion can be formed, so that the third or fourth semiconductor device of the present invention can be fabricated in a simple manner.

In each of the third or fourth semiconductor device formation methods of the present invention, it is preferable that the metal forming a metal oxide and a metal forming the metal film are the same element.

Thus, a transition layer and a metal film can be continuously formed, for example, only by changing film formation conditions. Accordingly, a barrier metal film having excellent adhesion can be formed, so that the third or fourth semiconductor device of the present invention can be fabricated in a simple manner.

A fifth method for fabricating a semiconductor device according to the present invention is characterized in that the method includes the steps of: forming a recess portion in an insulation film provided on a substrate; forming a barrier metal film containing oxygen as a component element so that the barrier metal film covers surfaces of the recess portion; and forming a buried wire on the barrier metal film so that the recess portion is filled, the step of forming the barrier metal film includes the step of forming the barrier metal such that a concentration of oxygen contained in the barrier metal film continuously varies in a film thickness direction of the barrier metal film.

According to the fifth semiconductor device fabrication method of the present invention, atomic layer deposition is used. Thus, only by continuously changing film formation conditions, a barrier metal film can be formed such that a concentration of oxygen continuously varies in a film thickness direction from a surface of the barrier metal film which is in contact with an insulation film to a surface thereof which is in contact with a buried wire. Accordingly, the barrier metal film does not have an interface at which a composition is remarkably changed, so that the strength of the second barrier metal film itself can be largely improved. Therefore, a highly reliable semiconductor device including a multi-layer wire with a low resistance and excellent adhesion can be fabricated.

### Effects of the invention

According to each of the first through fifth semiconductors and also each of the first through fifth methods for fabricating a semiconductor device, a highly reliable semiconductor device including a multi-layer wire with a low resistance and excellent adhesion can be achieved.

### BRIEF DESCRIPTION OF DRAWINGS

FIG. 1 is a cross-sectional view illustrating relevant part of a structure of a semiconductor device according to a first embodiment of the present invention.
FIG. 2 illustrates a distribution of atomic concentration in a thickness direction of a second barrier metal film according to the first embodiment of the present invention.
FIGS. **3(a)** and **3(b)** are cross-sectional views of relevant part of a semiconductor device according to the first embodiment of the present invention illustrating respective steps for fabricating the semiconductor device.
FIG. **4** is a cross-sectional view illustrating relevant part of a structure of a semiconductor device according to a second embodiment of the present invention.
FIG. **5** illustrates a distribution of atomic concentration in a thickness direction of a second barrier metal film according to the second embodiment of the present invention.
FIGS. **6(a)** through **6(c)** are cross-sectional views of relevant part of a semiconductor device according to the second embodiment of the present invention illustrating respective steps for fabricating the semiconductor device.
FIG. **7** is a cross-sectional view illustrating relevant part of a structure of a semiconductor device according to a third embodiment of the present invention.
FIG. **8** illustrates a distribution of atomic concentration in a thickness direction of a second barrier metal film according to the third embodiment of the present invention.
FIGS. **9(a)** through **9(c)** are cross-sectional views of relevant part of a semiconductor device according to the third embodiment of the present invention illustrating respective steps for fabricating the semiconductor device.
FIG. **10** is a cross-sectional view illustrating relevant part of a structure of a semiconductor device according to a fourth embodiment of the present invention.
FIG. **11** illustrates a distribution of atomic concentration in a thickness direction of a second barrier metal film according to the fourth embodiment of the present invention.
FIGS. **12(a)** through **12(c)** are cross-sectional views of relevant part of a semiconductor device according to the fourth embodiment of the present invention illustrating respective steps for fabricating the semiconductor device.
FIG. **13** is a cross-sectional view illustrating relevant part of a structure of a semiconductor device according to a fifth embodiment of the present invention.
FIG. **14** illustrates a distribution of atomic concentration in a thickness direction of a second barrier metal film according to the fifth embodiment of the present invention.
FIGS. **15(a)** and **15(b)** are cross-sectional views of relevant part of a semiconductor device according to the fifth embodiment of the present invention illustrating respective steps for fabricating the semiconductor device.
FIG. **16** is a cross-sectional view illustrating relevant part of a structure of a known semiconductor device.

### BEST MODE FOR CARRYING OUT THE INVENTION

### (First Embodiment)

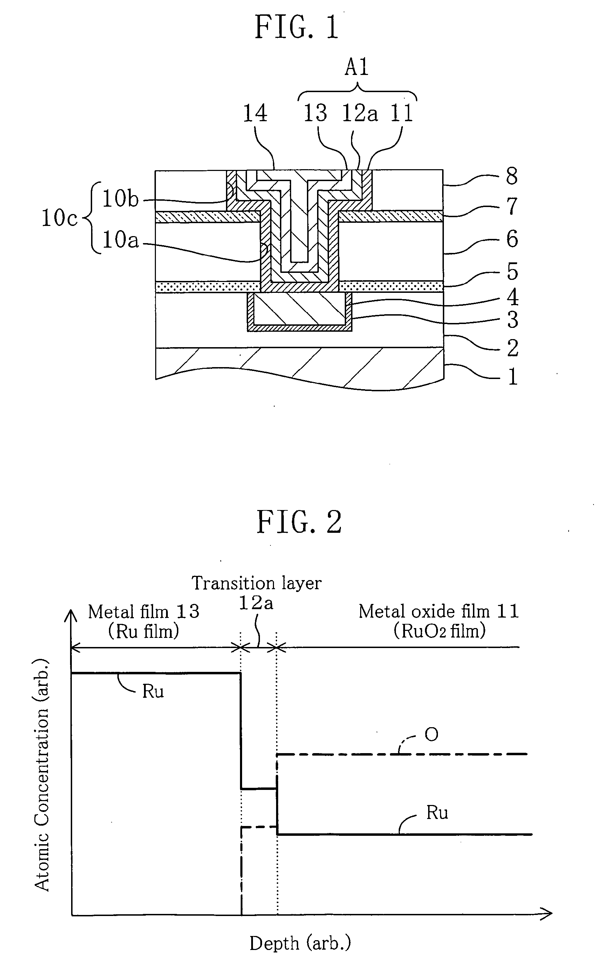

A semiconductor device according to a first embodiment of the present invention and a method for fabricating the semiconductor device will be described with reference to FIG. **1,** FIG. **2** and FIGS. **3(a)** through **3(c).**

FIG. 1 is a cross-sectional view illustrating relevant part of a structure of a semiconductor device according to the first embodiment of the present invention.

As shown in FIG. **1,** a first insulation film **2** which is an insulation film of a lower layer is formed on a silicon substrate **1.** A first copper wire **4** which is a copper wire of a lower layer including a first barrier metal film **3** is formed in the first insulation film **2.** On the silicon substrate **1,** a transistor and the like (not shown) are formed. A dielectric barrier film 5 for preventing diffusion of copper, a second insulation film **6,** a third insulation film **7** and a fourth insulation film **8** are formed in this order over the first insulation film 2 and the first copper wire **4.**

A via hole **10a** is formed in the dielectric barrier film 5, the second insulation film **6** and the third insulation film **7** so as to reach the first copper wire **4,** and a wiring groove **10b** is formed in the fourth insulating film **8** so as to communicate to the via hole **10a.** Thus, a recess portion **10c** including the via hole **10a** and the wiring groove **10b** which is to be a dual damascene wiring groove is formed.

Moreover, as shown in FIG. **1,** a second barrier metal film **A1** is formed on surfaces of the recess portion **10c.** The second barrier metal film **A1** is formed of a metal oxide film **11** formed on the dielectric barrier film **5,** the second insulation film **6,** the third insulation film 7 and the fourth insulation film **8** so as to cover the surfaces of the recess portion **10c,** a transition layer **12a** formed on the metal oxide film **11** and a metal film **13** formed on the transition layer **12a.** The transition layer **12a** is formed in the vicinity of an interface between the metal oxide film **11** and the metal film **13** and has substantially an intermediate composition between respective compositions of the metal oxide film **11** and the metal film **13.** Furthermore, the transition layer **12a** is formed of a single atomic layer.

FIG. **2** illustrates a distribution of atomic concentration in a thickness direction of the barrier metal film **A1,** for example, when a metal forming the metal film **13** is ruthenium (Ru) and the metal oxide film **11** is ruthenium oxide (RuO₂).

As shown in FIG. **2,** the transition layer **12a** of a single atomic layer is formed between the metal film **13** of ruthenium (Ru) and the metal oxide film **11** of ruthenium oxide (RuO₂). The transition layer **12a** has an intermediate composition between the respective compositions of the metal film 13 of ruthenium (Ru) and the metal oxide film **11** of ruthenium oxide (RuO₂). Specifically, a ruthenium (Ru) concentration in the transition layer **12a** is an intermediate concentration between a ruthenium (Ru) concentration in the metal film **13** and a ruthenium (Ru) concentration in the metal oxide film **11.** Moreover, an oxygen (0) concentration in the transition layer **12a** is an intermediate concentration between an oxygen (O) concentration in the metal film **13** (i.e., 0 in this case) and an oxygen (O) concentration of the metal oxide film **11.**

Furthermore, a second copper wire **14** which is made of copper and is a wire of an upper layer is formed on the metal film **13** so as to fill the inside of the recess portion **10c.** Note that the second copper wire **14** may be a wire, a via plug or a combination of a wire and a via plug. The second copper wire **14** may be formed of a copper alloy containing some other component (for example, a small amount of Si, Al, Mo, Si or the like) than pure copper and copper.

In this case, as the dielectric barrier film **5,** a silicon nitride film, a silicon nitride carbide film, a silicon carbide oxide film, a silicon carbide film or a lamination film formed of a combination of these films is preferably used. The dielectric barrier film **5** has the function of preventing diffusion of copper contained in the first copper wire **4** into the second insulation film **6** and the fourth insulation film **8.** As the third insulation film 7, the same material as that used for the dielectric barrier film **5** is preferably used. The third insulation film **7** is a film mainly functioning as an etching stopper for forming the wiring groove **10b.** When a sufficient etching selection ratio can be obtained between the second insulation film 6 and the fourth insulation film **8** or when etching for forming the wiring groove **10b** can be precisely formed, the third insulation film 7 is not necessarily provided.

Moreover, as each of the second insulation film **6** and the fourth insulation film **8,** a silicon oxide film, a fluorine-doped silicon oxide film, a silicon oxide carbide film or an insulation film of an organic film is preferably used. Each of these films may be a film formed by chemical vapor deposition or a SOD (spin on dielectric) film formed by spin coating. Moreover, the same material may be used for the second insulation film 6 and the fourth insulation film **8.**

As a metal forming the metal oxide film **11,** a refractory metal is preferably used. Thus, in the process step of forming a wire of an upper layer after formation of the second copper wire **14,** even when heat of about 400 °C is applied, the metal oxide film **11** does not degrade due to the heat treatment. Therefore, a highly reliable semiconductor device can be achieved.

When the metal oxide film **11** has a small thickness, the metal oxide film **11** does not necessarily have conductivity. However, it is preferable that the metal oxide film **11** has conductivity. Hereinafter, the metal oxide film **11** having conductivity will be specifically described.

As a metal forming the metal oxide film **11,** titanium (Ti), zirconium (Zr), hafnium (Hf), tantalum (Ta), niobium (Nb), tungsten (W), vanadium (V), molybdenum (Mo), ruthenium (Ru), osmium (Os), rhodium (Rh), iridium (Ir), palladium (Pd) or platinum (Pt) is preferably used.

It is more preferable that as a metal forming the metal oxide film **11,** vanadium (V), molybdenum (Mo), ruthenium (Ru), osmium (Os), rhodium (Ru), iridium (Ir), palladium (Pd) or platinum (Pt) is used. Thus, when the metal is oxidized, conductivity is not largely lost (or a resistivity is small), so that the second barrier metal film **A1** having a low resistance can be formed.

As a metal forming the metal film **13,** titanium (Ti), zirconium (Zr), hafnium (Hf), tantalum (Ta), niobium (Nb), tungsten (W), vanadium (V), molybdenum (Mo), ruthenium (Ru), osmium (Os), rhodium (Rh), iridium (Ir), palladium (Pd) or platinum is preferably used. For example, the resistivity of tantalum is 13 (µΩ·cm), the resistivity of ruthenium is 7.5 (µΩ·cm) and the resistivity of iridium is 6.5 (µΩ·cm).

It is more preferable that vanadium (V), molybdenum (Mo), ruthenium (Ru), osmium (Os), rhodium (Rh), iridium (Ir), palladium (Pd), platinum or the like is used. For example, the resistivity of ruthenium oxide film is 35 (µΩ·cm) and the resistivity of an iridium oxide film is 30 (µΩ·cm). With use of these metals, since the metals do not loose their conductivity (or have a low resistivity) when being oxidized, conductivity is not lost at surfaces of the metal oxide film **11** even when the surfaces of the metal oxide film 11 are oxidized in copper electroplating which will be later described. Accordingly, the second barrier metal film **A1** having a low resistance can be formed.

When the second barrier metal film **A1** is incorporated in an actual semiconductor device, the second barrier metal film **A1** is preferably formed so as to have a thickness of about several to 30 nm in a 65 nm generation semiconductor device. In a 45 nm generation semiconductor device, it is expected that the thickness of the second barrier metal film **A1** as a whole has to be about 15 nm or less at most. Note that this is also applied to second barrier metals **A2** through **A5** which will be described in the following embodiments.

As has been described, in the semiconductor device of the first embodiment of the present invention, the transition layer **12a** having substantially the intermediate composition between the respective compositions of the metal film **13** and the metal oxide film **11** exists at the interface between the metal film **13** and the metal oxide film **11.** Thus, adhesion between the metal film **13** and the metal oxide film **11** is remarkably improved, compared to the case where the transition layer **12a** does not exist at the interface between the metal film **13** and the metal oxide film **13.** Furthermore, since the transition layer **12a** is formed of a single atomic layer, in addition to improvement of adhesion between the metal film **13** and the metal oxide film **11,** a barrier metal film can be formed so as to have a small thickness by reducing the thickness of the transition layer **12a** to an absolute minimum even when the barrier metal film has a lamination structure, so that a resistance of a wire can be reduced. Therefore, a highly reliable semiconductor device including a multi-layer wire with a low resistance and excellent adhesion can be achieved.

A metal forming the metal oxide film **11** and a metal forming the metal film **13** may be different elements. In such a case, in a layer structure of the metal film **13/** the transition layer **12a**/ the metal oxide film **11/** an insulation film (i.e., each of the second insulation film **6,** the third insulation film **7** and the fourth insulation film **8),** adhesion between the metal oxide film **11** and the insulation film (i.e., each of the second insulation film **6,** the third insulation film **7** and the fourth insulation film **8)** can be optimized according to a kind of the insulation film (i.e., each of the second insulation film 6, the third insulation film **7** and the fourth insulation film **8)** without degrading adhesion between the metal film **13** and the metal oxide film **11.** Therefore, a highly reliable semiconductor device including a multi-layer wire with a low resistance and excellent adhesion can be achieved.

Moreover, a metal forming a metal oxide film and a metal forming a metal film may be the same element. In such a case, adhesion at an interface between the metal film **13** and the transition layer **12a** and adhesion at an interface between the transition layer **12a** and the metal oxide film **11** can be improved in a layer structure of the metal film **13**/the transition layer **12a/** the metal oxide film **11.** Therefore, a highly reliable semiconductor device including a multi-layer wire with a low resistance and excellent adhesion can be achieved.

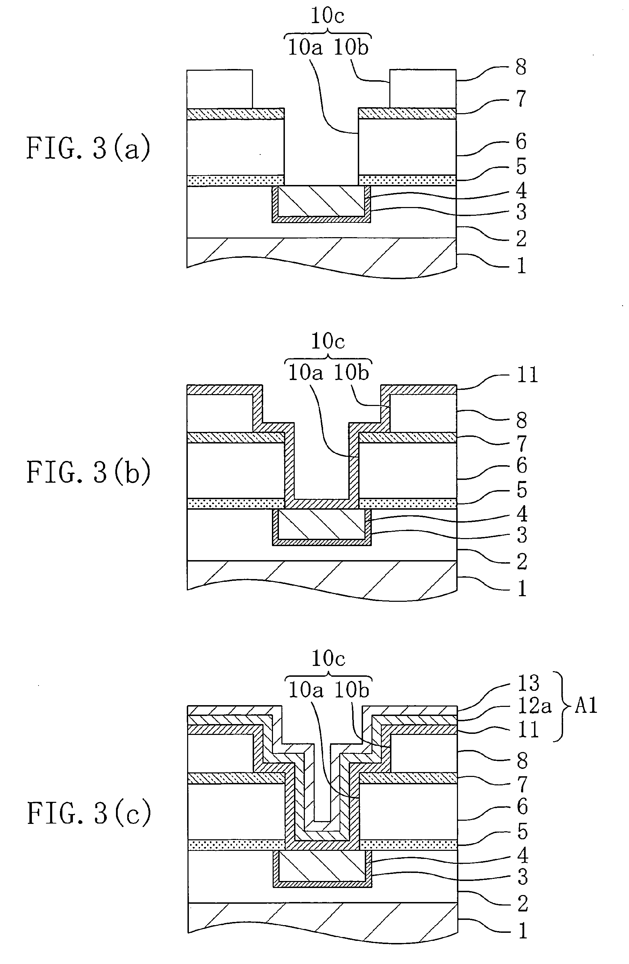

Next, a method for fabricating a semiconductor device according to the first embodiment of the present invention will be described with reference to FIG. **2** and FIGS. **3(a)** through **3(c).** Specifically, a method for fabricating the semiconductor device of FIG. 1 according to the first embodiment of the present invention will be hereinafter described.

FIGS. **3(a)** through **3(c)** are cross-sectional views of relevant part of a semiconductor device according to the first embodiment of the present invention illustrating respective steps for fabricating the semiconductor device.

First, as shown in FIG. **3(a),** a first insulation film **2** is formed on a silicon substrate **1** and then a first copper wire **4** including a first barrier metal film **3** is formed in the first insulation film **2.** On the silicon substrate **1,** a transistor and the like (not shown) are formed. Subsequently, a dielectric barrier film **5** for preventing diffusion of copper, a second insulation film **6,** a third insulation film **7** and a fourth insulation film **8** are formed in this order over the first insulation film **2** and the first copper wire **4.** Then, a via hole **10a** is formed in the dielectric barrier film **5,** the second insulation film **6** and the third insulation film **7** so that a lower end of the via hole **10a** reaches the first copper wire **4,** and a wiring groove **10b** is formed in the fourth insulation film **8** so as to communicate to the via hole **10a.** Thus, a recess portion **10c** including the via hole **10a** and the wiring groove **10b** for dual damascene is formed.

The recess portion **10c** including the via hole **10a** and the wiring groove **10b** is preferably formed by a dual damascene formation method disclosed, for example, in Japanese Laid-Open Publication No. 2002-75994 or the like using known lithography, etching, ashing, and cleaning.

Next, as shown in FIG. **3(b),** a metal oxide film **11** is formed on the second insulation film **6,** the third insulation film 7 and the fourth insulation film **8** so as to cover surfaces of the recess portion **10c.** In this case, the metal oxide film **11** is preferably formed by atomic layer deposition (ALD), chemical vapor deposition (CVD), physical vapor deposition (PVD) or like film formation method.

Next, as shown in FIG. **3(c),** a single cycle of deposition is performed by atomic layer deposition, thereby forming a transition layer **12a** on the metal oxide film **11.** Subsequently, a metal film **13** is formed by atomic layer deposition or physical vapor deposition. Thus, a second barrier metal film **A1** including the metal oxide film **11,** the transition layer **12a** and the metal film **13** is formed. In this case, the transition layer 12a has substantially an intermediate composition between respective compositions of the metal film **13** and the metal oxide film **11.**

Hereinafter, a method for forming the second barrier metal film **A1,** for example, in the case where a metal forming the metal film **13** is ruthenium (Ru) and the metal oxide film 11 is ruthenium oxide (RuO₂) will be described in detail.

A known atomic layer deposition technique (Journal of The Electrochemical Society, 151, G109-G112 (2004)) is used to form the metal oxide film **11,** the transition layer **12a** and the metal film **13** which together form the second barrier metal film **A1.** Conditions for film formation in this case are as follows. For example, Ru(EtCp)₂ (bis(ethylcyclopentadienyl)ruthenium) gas is used as a source gas of ruthenium (Ru). Where the source gas is heated to 80 °C, the source gas is diluted with Ar gas of 50 mL/min (standard temperature and pressure, dry) for use. The temperature of a substrate is 250 °C and the degree of vacuum is 4.66 × 10² Pa. As oxygen gas, a gas obtained by mixing Ar gas of 100 mL/min (standard temperature and pressure, dry) to oxygen gas of 70 mL/min (standard temperature and pressure, dry) is used. An arbitrary composition in the range from metal ruthenium to ruthenium oxide can be obtained by changing a pulse time used for supplying Ru(EtCp)₂ gas. The range of the pulse time is from 1 second to 10 seconds. After Ru(EtCp)₂ gas is supplied and then purged for a certain period of time, oxygen gas is supplied. When the supply of oxygen gas is stopped, purge is performed for a certain period of time. Thus, a film of a single atomic layer of Ru and O can be grown. This series of steps is assumed to be a cycle. When metal ruthenium is grown, oxygen gas is not supplied.

For example, with a pulse time of 2 seconds for supplying Ru(EtCp)₂ gas, a ruthenium oxide (RuO₂) film, i.e., the metal oxide film **11** is deposited on the second insulation film 6, the third insulation film 7 and the fourth insulation film **8** to a thickness of 5 nm and then, with a pulse time of 5 seconds for supplying Ru(EtCp)₂, a single atomic layer of the transition layer **12a** having an intermediate composition between respective compositions of ruthenium oxide is formed. Next, a ruthenium (Ru) film, i.e., the metal film **13** is deposited to a thickness of 5 nm with a pulse time of 10 seconds for supplying Ru(EtCp)₂. In the second barrier metal film **A1** formed in the above-described manner, a distribution of atomic concentration in the film thickness direction is as shown in FIG. 3. In this manner, the composition of the transition layer **12a** can be controlled in a simple manner by changing a pulse time.

Next, a copper film is formed over the metal film **13** as well as inside the recess portion 10c by copper electroplating so as to fill the recess portion **10c** and then parts of the copper film, the metal film **13,** the transition layer **12a** and the metal oxide film **11** located on the fourth insulation film **8,** except for parts thereof located inside the recess portion **10c,** are removed by CMP, thereby forming a second copper wire **14** and a via plug which is part of the second copper wire **14.** Thus, a semiconductor device having the structure of FIG. 1 can be obtained. A multi-layer wire can be formed by repeating the process steps from film formation of the dielectric barrier film **5** to CMP.

As has been described, according to the method for fabricating a semiconductor device according to the first embodiment of the present invention, the transition layer **12a** of a single atomic layer having substantially the intermediate composition between the respective compositions of the metal film **13** and the metal oxide film **11** can be formed at the interface between the metal film **13** and the metal oxide film **11** in a simple manner. Moreover, the same effects as those of the above-described semiconductor device can be achieved. Specifically, the transition layer **12a** having substantially the intermediate composition between the respective compositions of the metal film **13** and the metal oxide film **11** is formed at the interface between the metal film **13** and the metal oxide film **11,** so that adhesion between the metal film **13** and the metal oxide film **11** can be remarkably improved, compared to the case where the transition layer **12a** does not exist at the interface between the metal film **13** and the metal oxide film **11.** Furthermore, since the transition layer **12a** is formed of a single atomic layer, in addition to improvement of adhesion between the metal film 13 and the metal oxide film 11, a barrier metal film can be formed so as to have a small thickness by reducing the thickness of the transition layer **12a** to an absolute minimum even when the barrier metal film has a lamination structure, so that a resistance of a wire can be reduced. Therefore, a highly reliable semiconductor device including a multi-layer wire with a low resistance and excellent adhesion can be fabricated.

When the metal oxide film **11,** the transition layer **12a** and the metal film **13** are formed by atomic layer deposition using different metals for a metal forming the metal oxide film **11** and a metal forming the metal film **13,** respectively, the metal oxide film **11,** the transition layer **12a** and the metal film **13** can be continuously formed, for example, only by changing film formation conditions or a source gas. Accordingly, a second barrier metal film having excellent adhesion can be formed.

When the metal oxide film **11,** the transition layer **12a** and the metal film **13** are formed by atomic layer deposition using the same element for the metal forming the metal oxide film **11** and the metal forming the metal film **13,** the metal oxide film **11,** the transition layer **12a** and the metal film **13** can be continuously formed, for example, only by changing film formation conditions.

### (Second Embodiment)

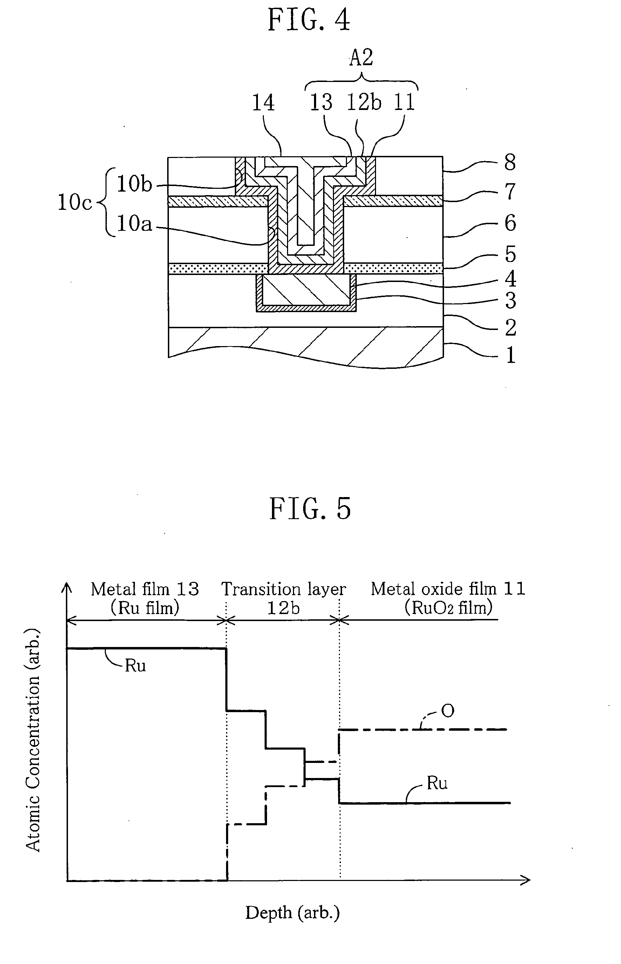

Hereinafter, a semiconductor device according to a second embodiment of the present invention and a method for fabricating the semiconductor device will be described with reference to FIG. **4,** FIG. **5** and FIGS. **6(a)** through **6(c).** The second embodiment has the same part as the first embodiment and therefore the description also shown in the first embodiment is not repeated. Hereinafter, the description will be given focusing on different points from the first embodiment.

FIG. **4** is a cross-sectional view illustrating relevant part of a structure of a semiconductor device according to the second embodiment of the present invention.

As shown in FIG. **4,** a second barrier metal film **A2** is formed on surfaces of a recess portion **10c.** The second barrier metal film **A2** is formed of a metal oxide film **11** formed on a dielectric barrier film **5,** a second insulation film **6,** a third insulation film **7** and a fourth insulation film **8** so as to cover the surfaces of the recess portion **10c,** a transition layer **12b** formed on the metal oxide film **11** and a metal film **13** formed on the transition layer **12b.** The transition layer **12b** is formed in the vicinity of an interface between the metal oxide film **11** and the metal film **13** and has substantially an intermediate composition between respective compositions of the metal oxide film **11** and the metal film **13.** Furthermore, the transition layer **12b** is formed of a plurality of atomic layers. FIG. **5** illustrates a distribution of atomic concentration in a thickness direction of the barrier metal film **A2,** for example, when a metal forming the metal film **13** is ruthenium (Ru) and the metal oxide film **11** is ruthenium oxide (RuO₂). The transition layer **12b** including three atomic layers is formed between the metal film **13** of ruthenium (Ru) and the metal oxide film **11** of ruthenium oxide (RuO₂). The transition layer **12b** has substantially an intermediate composition between respective compositions of the metal film **13** of ruthenium (Ru) and the metal oxide film of ruthenium oxide (RuO₂). Specifically, a ruthenium (Ru) concentration in the transition layer **12b** is an intermediate concentration between a ruthenium (Ru) concentration in the metal film **13** and a ruthenium (Ru) concentration in the metal oxide film **11.** An oxygen (O) concentration in the transition layer **12b** is an intermediate concentration between an oxygen (O) concentration in the metal film **13** (i.e., substantially 0 in this case) and an oxygen concentration in the metal oxide film **11.** Furthermore, the ruthenium (Ru) concentration in the transition layer **12b** decreases stepwise one atomic layer by one atomic layer in the direction from the metal film **13** of ruthenium (Ru) to the metal oxide film **11** of ruthenium oxide (RuO₂). On the other hand, the oxygen (O) concentration in the transition layer **12b** increases stepwise one atomic layer by one atomic layer in the direction from the metal film **13** of ruthenium (Ru) to the metal oxide film **11** of ruthenium oxide (RuO₂). That is, the composition of the transition layer **12b** varies stepwise.

As has been described, in the semiconductor device according to the second embodiment of the present invention, the transition layer **12b** having substantially the intermediate composition between the respective compositions of the metal film **13** and the metal oxide film **11** exists at the interface between the metal film **13** and the metal oxide film **11,** so that adhesion between the metal film 13 and the metal oxide film **11** is dramatically improved, compared to the case where the transition layer **12b** does not exist at the interface between the metal film 13 and the metal oxide film **11.** Accordingly, a barrier metal film having a small thickness and excellent adhesion can be formed. Furthermore, as another effect, the transition layer **12b** is formed of a plurality of atomic layers, so that adhesion is further improved, compared to the case where the transition layer **12b** provided between the metal film **13** and the metal oxide film **11** is formed of a single atomic layer. Moreover, the composition of the transition layer **12b** varies stepwise, so that adhesion is further improved. Therefore, a highly reliable semiconductor device including a multi-layer wire with a low resistance and excellent adhesion can be achieved.

A metal forming the metal oxide film **11** and a metal forming the metal film **13** may be different elements. In such a case, in a layer structure of the metal film **13/** the transition layer **12b/** the metal oxide film **11/** an insulation film (i.e., each of the second insulation film **6,** the third insulation film **7** and the fourth insulation film **8),** adhesion between the metal oxide film **11** and the insulation film (i.e., each of the second insulation film 6, the third insulation film **7** and the fourth insulation film **8)** can be optimized according to a kind of the insulation film (i.e., each of the second insulation film **6,** the third insulation film 7 and the fourth insulation film **8)** without degrading adhesion between the metal film **13** and the metal oxide film **11.** Therefore, a highly reliable semiconductor device including a multi-layer wire with a low cost and excellent adhesion can be achieved.

Moreover, a metal forming a metal oxide film and a metal forming a metal film may be the same element. In such a case, adhesion at an interface between the metal film **13** and the transition layer **12b** and adhesion at an interface between the transition layer **12b** and the metal oxide film **11** can be improved in a layer structure of the metal film **13**/the transition layer **12b/** the metal oxide film **11.** Therefore, a highly reliable semiconductor device including a multi-layer wire with a low resistance and excellent adhesion can be achieved.

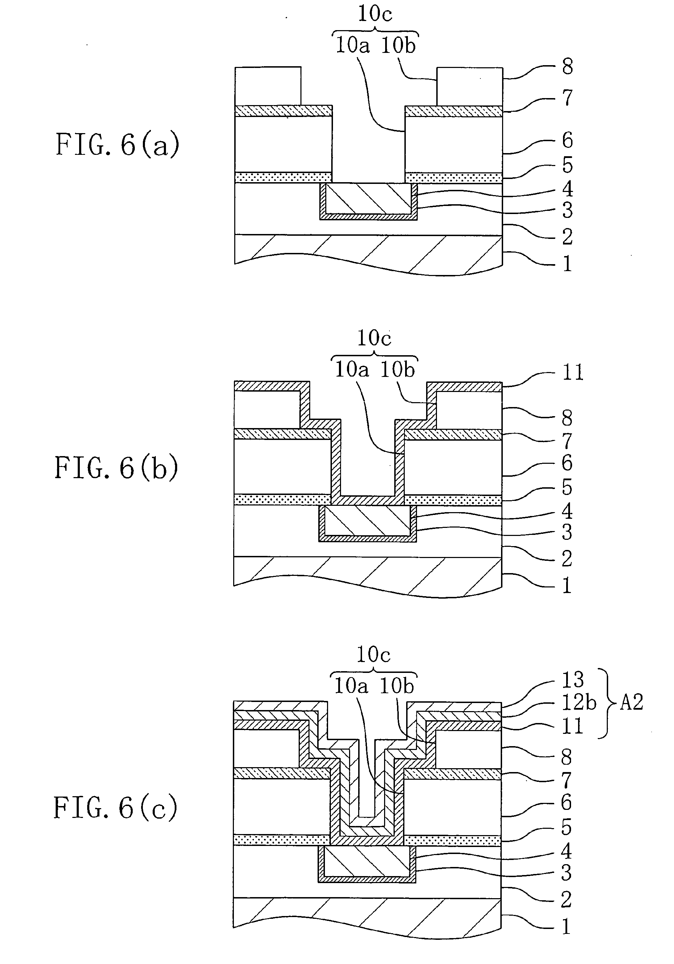

Next, a method for fabricating a semiconductor device according to the second embodiment of the present invention will be described with reference to FIG. **5** and FIGS. 6(a) through 6(c). Specifically, a method for fabricating the semiconductor device of the second embodiment shown in FIG. **4** will be hereinafter described.

First, in the same manner as shown in FIG. **2(a)** in the first embodiment, a recess portion 10c including a via hole **10a** and a wiring groove **10b** for dual damascene is formed as shown in FIG. **6(a).**

Next, as shown in FIG. **6(b),** a metal oxide film **11** is formed on the second insulation film 6, the third insulation film **7** and the fourth insulation film **8** so as to cover surfaces of the recess portion **10c.** In this case, the metal oxide film **11** is preferably formed by atomic layer deposition (ALD), chemical vapor deposition (CVD), physical vapor deposition (PVD) or like film formation method.

Next, as shown in FIG. **6(c),** a single cycle of deposition is performed by atomic layer deposition, thereby forming a transition layer **12b** on the metal oxide film **11.** Subsequently, a metal film **13** is formed on the transition layer **12b** by atomic layer deposition or physical vapor deposition. Thus, a second barrier metal film **A2** including the metal oxide film **11,** the transition layer **12b** and the metal film **13** is formed. In this case, the transition layer **12b** has substantially an intermediate composition between the respective compositions of the metal film **13** and the metal oxide film **11.**

Hereinafter, a method for forming the second barrier metal **A2,** for example, in the case where a metal forming the metal film **13** is ruthenium (Ru) and the metal oxide film **11** is ruthenium oxide (RuO₂) will be described in detail.

A known atomic layer deposition technique (Journal of The Electrochemical Society, 151, G109-G112 (2004)) is used to form the metal oxide film **11,** the transition layer **12b** and the metal film **13** which together form the second barrier metal film **A2.** Conditions for film formation in this case are as follows. For example, Ru(EtCp)₂ (bis(ethylcyclopentadienyl)ruthenium) gas is used as a source gas of ruthenium (Ru). Where the source gas is heated to 80 °C, the source gas is diluted with Ar gas of 50 mL/min (standard temperature and pressure, dry) for use. The temperature of a substrate is 250 °C and the degree of vacuum is 4.66 × 10² Pa. As oxygen gas, a gas obtained by mixing Ar gas of 100 mL/min (standard temperature and pressure, dry) to oxygen gas of 70 mL/min (standard temperature and pressure, dry) is used. An arbitrary composition in the range from metal ruthenium to ruthenium oxide can be obtained by changing a pulse time used for supplying Ru(EtC_{P})₂ gas. The range of the pulse time is from 1 second to 10 seconds. After Ru(EtCp)₂ gas is supplied and then purged for a certain period of time, oxygen gas is supplied. When the supply of oxygen gas is stopped, purge is performed for a certain period of time. Thus, a film of a single atomic layer of Ru and 0 can be grown. This series of steps is assumed to be a cycle. When metal ruthenium is grown, oxygen gas is not supplied.

For example, with a pulse time of 2 seconds for supplying Ru(EtCp)₂ gas, a ruthenium oxide (RuO₂) film, i.e., the metal oxide film **11** is deposited on the second insulation film 6, the third insulation film **7** and the fourth insulation film **8** to a thickness of 5 nm and then, with the pulse time for supplying Ru(EtCp)₂ changed stepwise to 3 seconds, 5 seconds and then 7 seconds, the transition layer **12b** having an intermediate composition between respective compositions of ruthenium oxide and ruthenium is formed, thereby obtaining a structure of three atomic layers. Next, a ruthenium (Ru) film, i.e., the metal film **13** is deposited to a thickness of 5 nm with a pulse time of 10 seconds for supplying Ru(EtCp)₂. In the second barrier metal film **A2** formed in the above-described manner, a distribution of atomic concentration in the film thickness direction is as shown in FIG. **5.** In this manner, the composition of the transition layer **12b** can be controlled in a simple manner by changing a pulse time. The composition of the transition layer **12b** as a whole preferably has the intermediate composition between ruthenium oxide and ruthenium. An atomic layer of the transition layer **12b** located closest to the metal oxide film **11** may be ruthenium oxide. In such a case, the atomic layer located closest to the metal oxide film **11** is preferably grown with a pulse time of 2 seconds for supplying Ru(EtCp)₂.

Next, a copper film is formed over the metal film **13** as well as inside the recess portion **10c** by copper electroplating so as to fill the recess portion **10c** and then parts of the copper film, the metal film **13,** the transition layer **12b** and the metal oxide film **11** located on the fourth insulation film **8,** except for parts thereof located inside the recess portion **10c,** are removed by CMP, thereby forming a second copper wire **14** and a via plug which is part of the second copper wire **14.** Thus, a semiconductor device having the structure of FIG. **4** can be obtained. A multi-layer wire can be formed by repeating the process steps from film formation of the dielectric barrier film **5** to CMP.

As described above, according to the method for fabricating a semiconductor device according to the second embodiment of the present invention, the transition layer **12b** having substantially the intermediate composition between the respective composition of the metal film **13** and the metal oxide film **11** and including a plurality of atomic layers can be formed in a simple manner at the interface between the metal film **13** and the metal oxide film **11.** Moreover, the same effects as those of the semiconductor device of the second embodiment can be achieved. Specifically, the transition layer **12b** having substantially the intermediate composition between the respective compositions of the metal film **13** and the metal oxide film **11** is formed at the interface between the metal film **13** and the metal oxide film **11,** so that adhesion between the metal film **13** and the metal oxide film **11** can be remarkably improved, compared to the case where the transition layer **12b** does not exist at the interface between the metal film **13** and the metal oxide film **11.** Accordingly, a barrier metal film having a small thickness and excellent adhesion can be formed. Furthermore, as another effect, since the transition layer **12b** is formed of a plurality of atomic layers, adhesion between the metal film **13** and the metal oxide film **11** is further improved, compared to the case where a transition layer provided between the metal film **13** and the metal oxide film **11** is formed of a single atomic layer. Moreover, adhesion can be further improved by changing the composition of the transition layer **12b** stepwise. Therefore, a highly reliable semiconductor device including a multi-layer wire with a low resistance and excellent adhesion can be fabricated.

When the metal oxide film **11,** the transition layer **12b** and the metal film **13** are formed by atomic layer deposition using different metals for a metal forming the metal oxide film **11** and a metal forming the metal film **13,** respectively, the metal oxide film **11,** the transition layer **12b** and the metal film **13** can be continuously formed, for example, only by changing film formation conditions or a source gas. Thus, a second barrier metal film having excellent adhesion can be formed.

When the metal oxide film **11,** the transition layer **12b** and the metal film **13** are formed by atomic layer deposition using the same element for the metal forming the metal oxide film **11** and the metal forming the metal film **13,** the metal oxide film **11,** the transition layer **12b** and the metal film **13** can be continuously formed, for example, only by changing film formation conditions.

### (Third Embodiment)

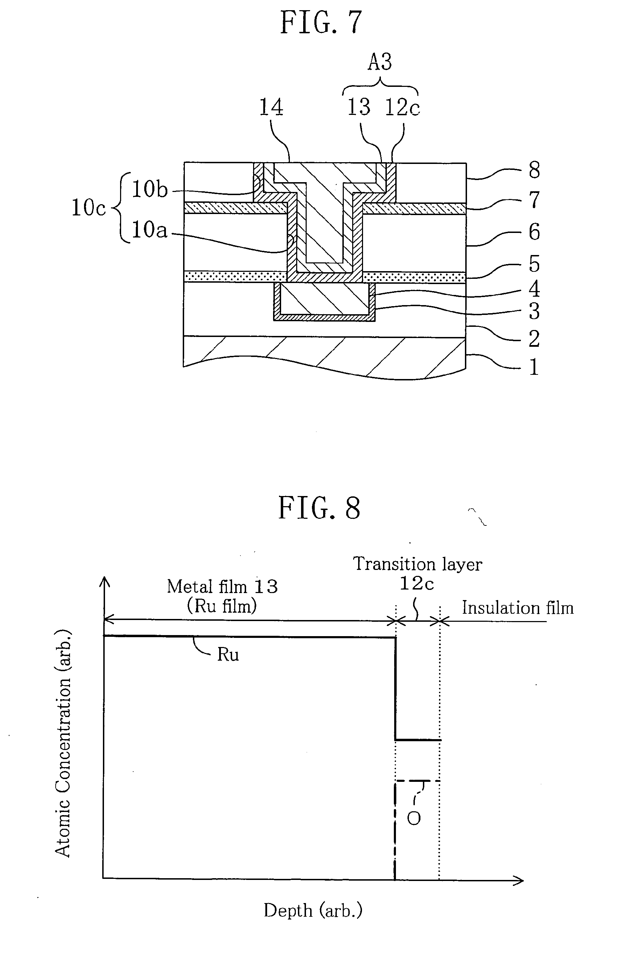

Hereinafter, a semiconductor device according to a third embodiment of the present invention and a method for fabricating the semiconductor device will be described with reference to FIGS. 7, FIG. **8** and FIGS. **9(a)** through **9(c).** The third embodiment has the same part as the first embodiment and therefore the description also shown in the first embodiment is not repeated. Hereinafter, the description will be given focusing on different points from the first embodiment.

FIG. **7** is a cross-sectional view illustrating relevant part of a structure of a semiconductor device according to the third embodiment of the present invention.

As shown in FIG. **7,** a second barrier metal **A3** is formed on surfaces of a recess portion **10c.** The second barrier metal film **A3** is formed of a transition layer **12c** formed on a dielectric barrier film **5,** a second insulation film **6,** a third insulation film **7** and a fourth insulation film **8** so as to cover the surfaces of the recess portion **10c** and a metal film **13** formed on the transition layer **12c.** The transition layer **12c** is formed in the vicinity of an interface between an insulation film (i.e., each of the second insulation film **6,** the third insulation film **7** and the fourth insulation film **8)** and the metal film **13** and has substantially an intermediate composition between respective compositions of a metal oxide and the metal film **13.** Furthermore, the transition layer **12c** is formed of a single atomic layer.

FIG. **8** illustrates a distribution of atomic concentration in a thickness direction of the barrier metal film **A3,** for example, when a metal forming the metal film **13** is ruthenium (Ru) and the metal oxide is ruthenium oxide (RuO₂). The transition layer **12c** of a single atomic layer is formed between the metal film **13** of ruthenium (Ru) and the insulation film (i.e., each of the second insulation film 6, the third insulation film **7** and the fourth insulation film **8).** The transition layer **12c** has substantially the intermediate composition between the respective compositions of the metal film **13** of ruthenium (Ru) and the metal oxide of ruthenium oxide (RuO₂). Specifically, a ruthenium (Ru) concentration in the transition layer **12c** is an intermediate concentration between a ruthenium (Ru) concentration in the metal film **13** and a ruthenium (Ru) concentration in the metal oxide of ruthenium oxide (RuO₂). An oxygen (O) concentration in the transition layer **12c** is an intermediate concentration between an oxygen (O) concentration in the metal film **13** (i.e., substantially 0 in this case) and an oxygen (O) concentration in the metal oxide of ruthenium oxide (RuO₂).

A refractory metal is preferably used as a metal for forming the metal oxide which determines the composition of the transition layer **12c.** Thus, in the process step of forming a wire of an upper layer after formation of a second copper wire **14,** even when heat of about 400 °C is applied, the transition layer **12c** does not degrade due to the heat treatment. Therefore, a highly reliable semiconductor device can be achieved.

Moreover, when the transition layer **12c** has a small thickness, the transition layer **12c** does not necessarily have conductivity. However, the transition layer 12c preferably has conductivity. Hereinafter, the metal oxide which determines the composition of the transition layer **12c** having conductivity will be specifically described.

As a metal forming the metal oxide which determines the composition of the transition layer **12c,** titanium (Ti), zirconium (Zr), hafnium (Hf), tantalum (Ta), niobium (Nb), tungsten (W), vanadium (V), molybdenum (Mo), ruthenium (Ru), osmium (Os), rhodium (Rh), iridium (Ir), palladium (Pd) or platinum (Pt) is preferably used.

It is more preferable that as the metal forming the metal oxide which determines the composition of the transition layer **12c,** vanadium (V), molybdenum (Mo), ruthenium (Ru), osmium (Os), rhodium (Rh), iridium (Ir), palladium (Pd), platinum (Pt) or the like is used. Thus, when the metal is oxidized, conductivity is not largely lost (or a resistivity is small), so that the second barrier metal film **A3** having a low resistance can be formed.

As described above, in the semiconductor device according to the third embodiment of the present invention, the transition layer **12c** having substantially the intermediate composition between the respective compositions of the metal film **13** and the metal oxide exists at the interface between the metal film **13** and an insulation film (i.e., each of the second insulation film **6,** the third insulation film **7** and the fourth insulation film **8),** so that adhesion between the metal film **13** and the insulation film (i.e., each of the second insulation film 6, the third insulation film 7 and the fourth insulation film **8)** is remarkably improved, compared to the case where the transition layer **12c** does not exist at the interface between the metal film 13 and the insulation film (i.e., each of the second insulation film **6,** the third insulation film **7** and the fourth insulation film **8).** Furthermore, since the transition layer **12c** is formed of a single atomic layer, in addition to improvement of adhesion between the metal film **13** and the insulation film (i.e., each of the second insulation film **6,** the third insulation film 7 and the fourth insulation film **8),** a barrier metal film can be formed so as to have a small thickness by reducing the thickness of the transition layer 12c to an absolute minimum even when the barrier metal film has a lamination structure, so that a resistance of a wire can be reduced. Therefore, a highly reliable semiconductor device including a multi-layer wire with a low resistance and excellent adhesion can be achieved.

A metal forming the metal oxide which determines the composition of the transition layer **12c** and a metal forming the metal film **13** may be different elements. In such a case, in a layer structure of the metal film **13/** the transition layer **12c/** an insulation film (i.e., each of the second insulation film **6,** the third insulation film **7** and the fourth insulation film **8),** adhesion between the transition layer **12c** and the insulation film (i.e., each of the second insulation film **6,** the third insulation film 7 and the fourth insulation film **8)** can be optimized according to a kind of the insulation film (i.e., each of the second insulation film **6,** the third insulation film **7** and the fourth insulation film **8)** without degrading adhesion between the metal film **13** and the transition layer **12c.** Therefore, a highly reliable semiconductor device including a multi-layer wire with a low resistance and excellent adhesion can be achieved.

Moreover, a metal forming the metal oxide which determines the composition of the transition layer **12c** and a metal forming the metal film **13** may be the same element. In such a case, adhesion at an interface between the metal film **13** and the transition layer **12c** can be improved in a layer structure of the metal film **13/** the transition layer **12c.** Therefore, a highly reliable semiconductor device including a multi-layer wire with a low resistance and excellent adhesion can be achieved.

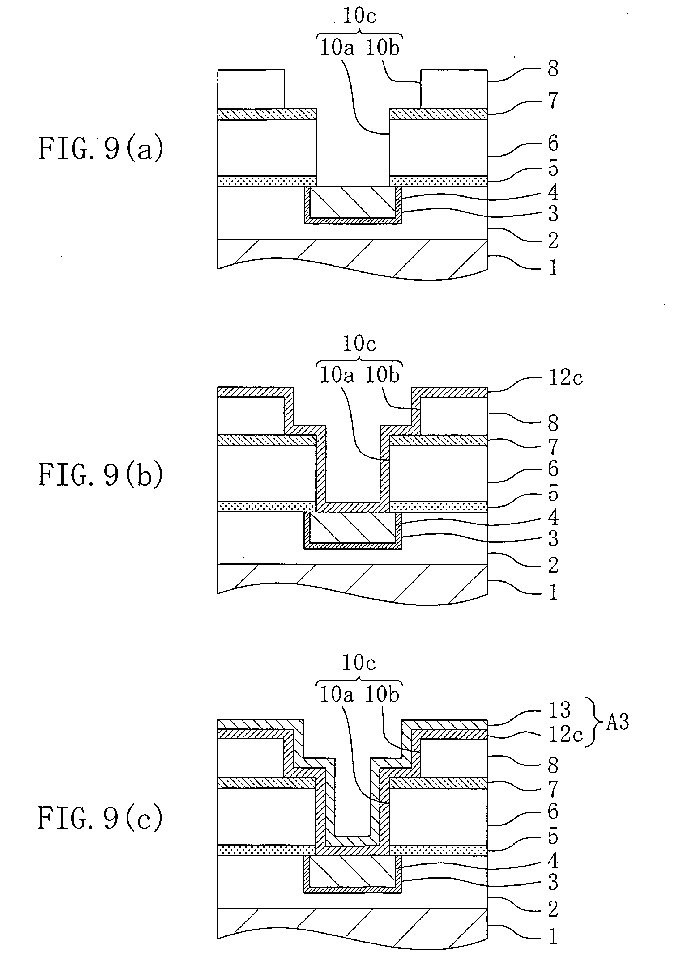

Next, a method for fabricating a semiconductor device according to the third embodiment of the present invention will be described with reference to FIG. **8** and FIGS. **9(a)** through **9(c).** Specifically, a method for fabricating the semiconductor device of FIG. 7 according to the third embodiment of the present invention will be hereinafter described.

FIGS. **9(a)** through **9(c)** are cross-sectional views of relevant part of a semiconductor device according to the third embodiment of the present invention illustrating respective steps for fabricating the semiconductor device.

First, in the same manner as shown in FIG. **2(a)** in the first embodiment, a recess portion **10c** including a via hole **10a** and a wiring groove **10b** for dual damascene is formed as shown in FIG. **9(a).**

Next, as shown in FIG. **9(b),** a single cycle of deposition is performed by atomic layer deposition, thereby forming a transition layer **12c** on the second insulation film **6,** the third insulation film 7 and the fourth insulation film **8** so as to cover surfaces of the recess portion **10c.**

Next, as shown in FIG, **9(c),** a metal film **13** is formed on the transition layer **12c** by atomic layer deposition or physical vapor deposition. Thus, the second barrier metal film **A3** including the transition layer **12c** and the metal film **13** is formed. In this case, the transition layer **12c** has substantially an intermediate composition between the respective compositions of the metal film **13** and a metal oxide.

Hereinafter, a method for forming the second barrier metal **A3,** for example, in the case where a metal forming the metal film **13** is ruthenium (Ru) and the metal oxide which determines the composition of the transition layer **12c** is ruthenium oxide (RuO₂) will be described in detail.

A known atomic layer deposition technique (Journal of The Electrochemical Society, 151, G109-G112 (2004)) is used to form the transition layer **12c** and the metal film **13** which together form the second barrier metal film **A3.** Conditions for film formation in this case are as follows. For example, Ru(EtCp)₂ (bis(ethylcyclopentadienyl)ruthenium) gas is used as a source gas of ruthenium (Ru). Where the source gas is heated to 80 °C, the source gas is diluted with Ar gas of 50 mL/min (standard temperature and pressure, dry) for use. The temperature of a substrate is 250 °C and the degree of vacuum is 4.66 × 10² Pa. As oxygen gas, a gas obtained by mixing Ar gas of 100 mL/min (standard temperature and pressure, dry) to oxygen gas of 70 mL/min (standard temperature and pressure, dry) is used. An arbitrary composition in the range from metal ruthenium to ruthenium oxide can be obtained by changing a pulse time used for supplying Ru(EtC_{P})₂ gas. The range of the pulse time is from 1 second to 10 seconds. After Ru(EtC_{P})₂ gas is supplied and then purged for a certain period of time, oxygen gas is supplied. When the supply of oxygen gas is stopped, purge is performed for a certain period of time. Thus, a film of a single atomic layer of Ru and 0 can be grown. This series of steps is assumed to be a cycle. When metal ruthenium is grown, oxygen gas is not supplied.

For example, a single atomic layer of the transition layer 12c having an intermediate composition between respective compositions of ruthenium oxide and ruthenium is formed with a pulse time of 5 seconds for supplying Ru(EtC_{P})₂. Next, with a pulse time of 10 seconds for supplying Ru(EtC_{P})₂, a ruthenium (Ru) film, i.e., the metal film **13** is deposited to a thickness of 5 nm. In the second barrier metal film **A3** formed in the above-described manner, a distribution of atomic concentration in the film thickness direction is as shown in FIG. **8.** In this manner, the composition of the transition layer **12c** can be controlled in a simple manner by changing a pulse time.

Next, a copper film is formed over the metal film **13** as well as inside the recess portion **10c** by copper electroplating so as to fill the recess portion **10c** and then parts of the copper film, the metal film **13** and the transition layer **12c** located on the fourth insulation film **8,** except for parts thereof located inside the recess portion **10c,** are removed by CMP, thereby forming a second copper wire **14** and a via plug which is part of the second copper wire **14.** Thus, a semiconductor device having the structure of FIG. 7 can be obtained. A multi-layer wire can be formed by repeating the process steps from film formation of the dielectric barrier film 5 to CMP.

As has been described, according to the method for fabricating a semiconductor device according to the third embodiment of the present invention, the transition layer **12c** of a single atomic layer having substantially the intermediate composition between the respective compositions of the metal film **13** and the metal oxide can be formed at an interface between the metal film **13** and the insulation film (i.e., each of the second insulation film **6,** the third insulation film 7 and the fourth insulation film **8)** in a simple manner. Moreover, the same effects as those of the above-described semiconductor device can be achieved. Specifically, the transition layer **12c** having substantially the intermediate composition between the respective compositions of the metal film **13** and the metal oxide is formed at the interface between the metal film **13** and the insulation film (i.e., each of the second insulation film **6,** the third insulation film **7** and the fourth insulation film 8), so that adhesion between the metal film **13** and the insulation film (i.e., each of the second insulation film **6,** the third insulation film **7** and the fourth insulation film **8)** can be remarkably improved, compared to the case where the transition layer **12c** does not exist at the interface between the metal film **13** and the insulation film (i.e., each of the second insulation film **6,** the third insulation film 7 and the fourth insulation film **8).** Furthermore, since the transition layer **12c** is formed of a single atomic layer, in addition to improvement of adhesion between the metal film **13** and the insulation film (i.e., each of the second insulation film **6,** the third insulation film **7** and the fourth insulation film **8),** a barrier metal film can be formed so as to have a small thickness by reducing the thickness of the transition layer **12c** to an absolute minimum even when the barrier metal film has a lamination structure, so that a resistance of a wire can be reduced. Therefore, a highly reliable semiconductor device including a multi-layer wire with a low resistance and excellent adhesion can be fabricated.

When the transition layer **12c** and the metal film **13** are formed by atomic layer deposition using different metals for a metal forming the metal oxide and a metal forming the metal film **13,** respectively, the transition layer **12c** and the metal film **13** can be continuously formed, for example, only by changing film formation conditions or a source gas.

When the transition layer **12c** and the metal film **13** are formed by atomic layer deposition using the same element for the metal forming the metal oxide and the metal forming the metal film **13,** the transition layer **12c** and the metal film **13** can be continuously formed, for example, only by changing film formation conditions.

### (Fourth Embodiment)

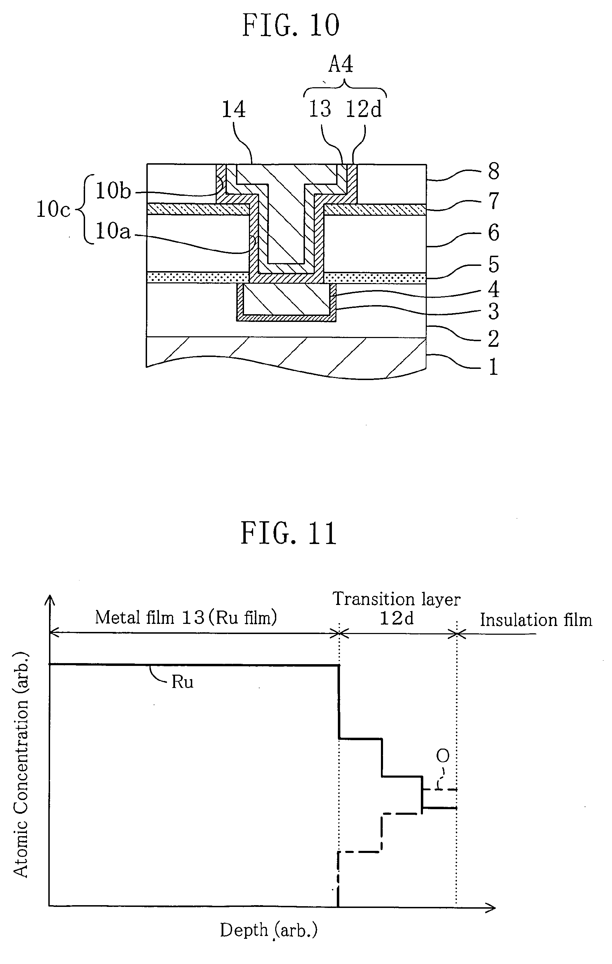

Hereinafter, a semiconductor device according to a fourth embodiment of the present invention and a method for fabricating the semiconductor device will be described with reference to FIGS. **10,** FIG. **11** and FIGS. **12(a)** through **12(c).** The fourth embodiment has the same part as the third embodiment and therefore the description also shown in the third embodiment is not repeated. Hereinafter, the description will be given focusing on different points from the third embodiment.

FIG. **10** is a cross-sectional view illustrating relevant part of a structure of a semiconductor device according to the fourth embodiment of the present invention.

As shown in FIG. **10,** a second barrier metal film **A4** is formed on surfaces of a recess portion **10c.** The second barrier metal film **A4** is formed of a transition layer **12d** formed on a dielectric barrier film **5,** a second insulation film **6,** a third insulation film 7 and a fourth insulation film **8** so as to cover the surfaces of the recess portion **10c** and a metal film **13** formed on the transition layer **12d.** The transition layer **12d** is formed in the vicinity of an interface between an insulation film (i.e., each of the second insulation film **6,** the third insulation film **7** and the fourth insulation film **8)** and the metal film **13** and has substantially an intermediate composition between respective compositions of a metal oxide and the metal film **13.** Furthermore, the transition layer **12d** is formed of a plurality of atomic layers. FIG. **11** illustrates a distribution of atomic concentration in a thickness direction of the barrier metal film **A4,** for example, when a metal forming the metal film **13** is ruthenium (Ru) and a metal oxide which determines the composition of the transition layer **12d** is ruthenium oxide (RuO₂). The transition layer **12d** including three atomic layers is formed between the metal film **13** of ruthenium (Ru) and the insulation film (each of the second insulation film **6,** the third insulation film 7 and the fourth insulation film **8).** The transition layer **12d** has substantially the intermediate composition between the respective compositions of the metal film **13** of ruthenium (Ru) and the metal oxide of ruthenium oxide (RuO₂). Specifically, a ruthenium (Ru) concentration in the transition layer **12d** is an intermediate concentration between a ruthenium (Ru) concentration in the metal film **13** and a ruthenium concentration (Ru) in the metal oxide of ruthenium oxide (RuO₂). An oxygen (O) concentration in the transition layer **12d** is an intermediate concentration between an oxygen (O) concentration in the metal film **13** (i.e., substantially 0 in this case) and an oxygen (O) concentration in the metal oxide of ruthenium oxide (RuO₂). Furthermore, the ruthenium (Ru) concentration in the transition layer **12d** decreases stepwise one atomic layer by one atomic layer in the direction from the metal film **13** of ruthenium (Ru) to the insulation film (each of the second insulation film 6, the third insulation film 7 and the fourth insulation film **9).** On the other hand, the oxygen (O) concentration in the transition layer **12d** increases stepwise one atomic layer by one atomic layer in the direction from the metal film **13** of ruthenium (Ru) to the insulation film (each of the second insulation film **6,** the third insulation film 7 and the fourth insulation film 9). That is, the composition of the transition layer **12d** varies stepwise.

As has been described, in the semiconductor device according to the fourth embodiment of the present invention, the transition layer **12d** having substantially the intermediate composition between the respective compositions of the metal film **13** and the metal oxide exists at the interface between the metal film **13** and an insulation film (i.e., each of the second insulation film 6, the third insulation film **7** and the fourth insulation film **8),** so that adhesion between the metal film **13** and the insulation film (i.e., each of the second insulation film 6, the third insulation film **7** and the fourth insulation film **8)** is remarkably improved, compared to the case where the transition layer **12d** does not exist at the interface between the metal film **13** and the insulation film (i.e., each of the second insulation film 6, the third insulation film 7 and the fourth insulation film **8).** Thus, a barrier metal film having a small thickness and excellent adhesion can be formed. Furthermore, as another effect, the transition layer **12d** is formed of a plurality of atomic layers, so that adhesion is further improved, compared to the case where the transition layer **12d** provided between the metal film **13** and the insulation film (i.e., the second insulation film 6, the third insulation film 7 and the fourth insulation film **8)** is formed of a single atomic layer. Moreover, the composition of the transition layer **12d** varies stepwise, so that adhesion is further improved. Therefore, a highly reliable semiconductor device including a multi-layer wire with a low resistance and excellent adhesion can be achieved.

A metal forming the metal oxide which determines the composition of the transition layer **12d** and a metal forming the metal film **13** may be different elements. In such a case, in a layer structure of the metal film **13/** the transition layer **12d/** an insulation film (i.e., each of the second insulation film **6,** the third insulation film **7** and the fourth insulation film **8),** adhesion between the transition layer **12d** and the insulation film (i.e., each of the second insulation film **6,** the third insulation film **7** and the fourth insulation film **8)** can be optimized according to a kind of the insulation film (i.e., each of the second insulation film **6,** the third insulation film **7** and the fourth insulation film **8)** without degrading adhesion between the metal film **13** and the transition layer **12d.** Therefore, a highly reliable semiconductor device including a multi-layer wire with a low resistance and excellent adhesion can be achieved.

Moreover, a metal forming the metal oxide film which determines the composition of the transition layer **12d** and a metal forming the metal film **13** may be the same element. In such a case, adhesion at an interface between the metal film **13** and the transition layer **12d** can be improved in a layer structure of the metal film **13/** the transition layer **12d.** Therefore, a highly reliable semiconductor device including a multi-layer wire with a low resistance and excellent adhesion can be achieved.

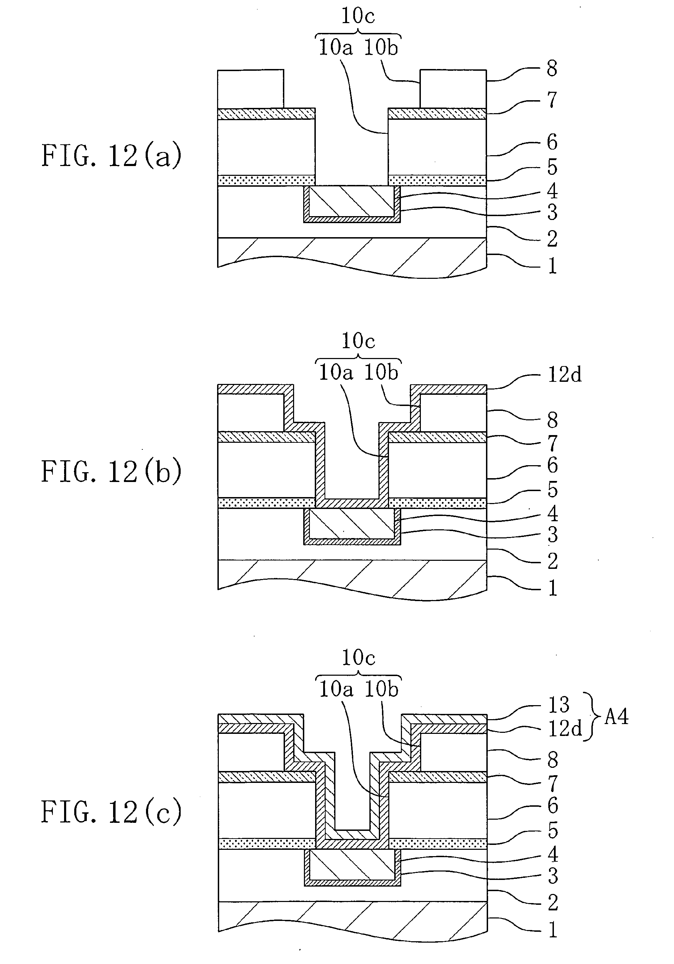

Next, a method for fabricating a semiconductor device according to the fourth embodiment of the present invention will be described with reference to FIG. **11** and FIGS. **12(a)** through **12(c).** Specifically, a method for fabricating the semiconductor device of FIG. 10 according to the fourth embodiment of the present invention will be hereinafter described.

FIGS. **12(a)** through **12(c)** are cross-sectional views of relevant part of a semiconductor device according to the fourth embodiment of the present invention illustrating respective steps for fabricating the semiconductor device.

First, in the same manner as shown in FIG. **2(a)** in the first embodiment, as shown in FIG. **12(a),** a recess portion **10c** including a via hole **10a** and a wiring groove **10b** for dual damascene is formed.

As shown in FIG. **12(b),** a single cycle of deposition is performed by atomic layer deposition, thereby forming a transition layer **12d** is formed on the second insulation film **6,** the third insulation film 7 and the fourth insulation film **8** so as to cover surfaces of the recess portion **10c.**

Next, as shown in FIG, **12(c),** a metal film **13** is formed on the transition layer **12d** by atomic layer deposition or physical vapor deposition. Thus, a second barrier metal film **A4** including the transition layer **12d** and the metal film **13** is formed. In this case, the transition layer **12d** has substantially an intermediate composition between the respective compositions of the metal film **13** and a metal oxide.

Hereinafter, a method for forming the second barrier metal **A4,** for example, in the case where a metal forming the metal film **13** is ruthenium (Ru) and the metal oxide which determines the composition of the transition layer **12d** is ruthenium oxide (RuO₂) will be described in detail.

A known atomic layer deposition technique (Journal of The Electrochemical Society, 151, G109-G112 (2004)) is used to form the transition layer **12d** and the metal film **13** which together form the second barrier metal film **A4.** Conditions for film formation in this case are as follows. For example, Ru(EtCp)₂ (bis(ethylcyclopentadienyl)ruthenium) gas is used as a source gas of ruthenium (Ru). Where the source gas is heated to 80 °C, the source gas is diluted with Ar gas of 50 mL/min (standard temperature and pressure, dry) for use. The temperature of a substrate is 250 °C and the degree of vacuum is 4.66 × 10² Pa. As oxygen gas, a gas obtained by mixing Ar gas of 100 mL/min (standard temperature and pressure, dry) to oxygen gas of 70 mL/min (standard temperature and pressure, dry) is used. An arbitrary composition in the range from metal ruthenium to ruthenium oxide can be obtained by changing a pulse time used for supplying Ru(EtCp)₂ gas. The range of the pulse time is from 1 second to 10 seconds. After Ru(EtCp)₂ gas is supplied and then purged for a certain period of time, oxygen gas is supplied. When the supply of oxygen gas is stopped, purge is performed for a certain period of time. Thus, a film of a single atomic layer of Ru and O can be grown. This series of steps is assumed to be a cycle. When metal ruthenium is grown, oxygen gas is not supplied.

For example, with the pulse time for supplying Ru(EtCp)₂ changed in a stepwise manner to 3 seconds, 5 seconds and then 7 seconds, the transition layer 12d having an intermediate composition between respective compositions of ruthenium oxide and ruthenium is formed on the second insulation film **6,** the third insulation film 7 and the fourth insulation film **8,** thereby obtaining a structure of three atomic layers. Next, with a pulse time of 10 seconds for supplying Ru(EtCp)₂, a ruthenium (Ru) film, i.e., the metal film **13** is deposited to a thickness of 5 nm. In the second barrier metal film **A4** formed in the above-described manner, a distribution of atomic concentration in the film thickness direction is as shown in FIG. **11.** In this manner, the composition of the transition layer **12d** can be controlled in a simple manner by changing a pulse time. The composition of the transition layer **12d** as a whole preferably has the intermediate composition between ruthenium oxide and ruthenium. An atomic layer of the transition layer **12d** located closest to the metal oxide film **11** may be ruthenium oxide. In such a case, the atomic layer located closest to the metal oxide film **11** is preferably grown with a pulse time of 2 seconds for supplying Ru(EtCp)₂.

Next, a copper film is formed over the metal film **13** as well as inside the recess portion **10c** by copper electroplating so as to fill the recess portion **10c** and then parts of the copper film, the metal film **13** and the transition layer **12d** located on the fourth insulation film **8,** except for parts thereof located inside the recess portion **10c,** are removed by CMP, thereby forming a second copper wire **14** and a via plug which is part of the second copper wire **14.** Thus, a semiconductor device having the structure of FIG. 10 can be obtained. A multi-layer wire can be formed by repeating the process steps from film formation of the dielectric barrier film 5 to CMP.

As has been described, according to the method for fabricating a semiconductor device according to the fourth embodiment of the present invention, the transition layer **12d** having substantially the intermediate composition between the respective composition of the metal film **13** and the metal oxide and including a plurality of atomic layers can be formed in a simple manner at the interface between the metal film **13** and the insulation film (i.e., each of the second insulation film **6,** the third insulation film **7** and the fourth insulation film **8).** Moreover, the same effects as those of the semiconductor device of the fourth embodiment can be achieved. Specifically, the transition layer **12d** having substantially an intermediate composition between the respective compositions of the metal film **13** and the metal oxide is formed at the interface between the metal film **13** and the insulation film (i.e., each of the second insulation film **6,** the third insulation film **7** and the fourth insulation film **8),** so that adhesion between the metal film **13** and the insulation film (i.e., each of the second insulation film **6,** the third insulation film 7 and the fourth insulation film **8)** can be remarkably improved, compared to the case where the transition layer **12d** does not exist at the interface between the metal film 13 and the insulation film (i.e., each of the second insulation film 6, the third insulation film 7 and the fourth insulation film **8).** Accordingly, a barrier metal film having a small thickness and excellent adhesion can be formed. Furthermore, as another effect, since the transition layer **12d** is formed of a plurality of atomic layers, adhesion between the metal film **13** and the insulation film (i.e., each of the second insulation film **6,** the third insulation film **7** and the fourth insulation film **8)** is further improved, compared to the case where a transition layer provided between the metal film **13** and the insulation film (i.e., each of the second insulation film 6, the third insulation film 7 and the fourth insulation film **8)** is formed of a single atomic layer. Moreover, adhesion can be further improved by changing the composition of the transition layer **12d** stepwise. Therefore, a highly reliable semiconductor device including a multi-layer wire with a low resistance and excellent adhesion can be fabricated.

When the transition layer **12d** and the metal film **13** are formed by atomic layer deposition using different metals for a metal forming the metal oxide and a metal forming the metal film **13,** respectively, the transition layer **12d** and the metal film **13** can be continuously formed, for example, only by changing film formation conditions or a source gas.

When the transition layer **12d** and the metal film **13** are formed by atomic layer deposition using the same element for the metal forming the metal oxide and the metal forming the metal film **13,** the transition layer **12d** and the metal film **13** can be continuously formed, for example, only by changing film formation conditions.

### (Fifth Embodiment)

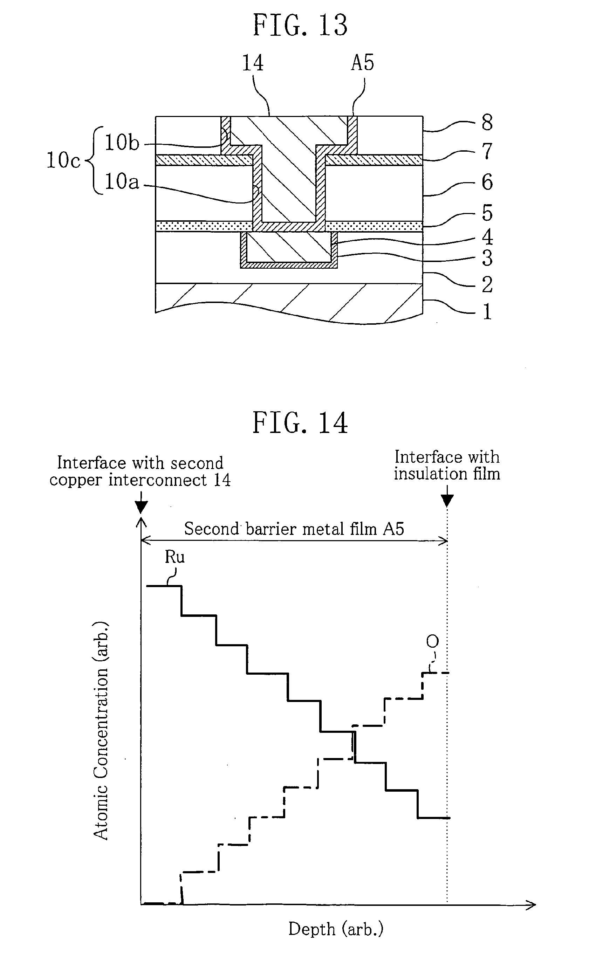

Hereinafter, a semiconductor device according to a fifth embodiment of the present invention and a method for fabricating the semiconductor device will be described with reference to FIG. **13,** FIG. **14** and FIGS. **15(a)** through **15(c).** The fifth embodiment has the same part as the first embodiment and therefore the description also shown in the first embodiment is not repeated. Hereinafter, the description will be given focusing on different points from the first embodiment.

FIG. **13** is a cross-sectional view illustrating relevant part of a structure of a semiconductor device according to the fifth embodiment of the present invention.

As shown in FIG. **13,** a second barrier metal film **A5** is formed on surfaces of a recess portion **10c.** The second barrier metal film **A5** is formed of a film containing oxygen as a component element. The oxygen concentration in the second barrier metal film **A5** continuously varies in the film thickness direction from an insulation film (i.e., a second insulation film **6,** a third insulation film **7** and a fourth insulation film **8)** to a second copper wire **14.**

FIG. **14** illustrates a distribution of atomic concentration in a thickness direction of the barrier metal film **A5,** for example, when the second barrier metal film **A5** is a film in which an oxygen distribution continuously varies from ruthenium (Ru) to ruthenium oxide (RuO₂). A ruthenium (Ru) layer is formed in the vicinity of an interface between the second copper wire **14** and the second barrier metal film **A5.** A ruthenium oxide (RuO₂) layer is formed in the vicinity of an interface between the second barrier metal film **A5** and an insulation film (i.e., each of the second insulation film 6, the third insulation film **7** and the fourth insulation film **8).** In the direction from the second copper wire **14** to the insulation film (i.e., each of the second insulation film 6, the third insulation film **7** and the fourth insulation film **8),** while the oxygen concentration continuously increases, the ruthenium (Ru) concentration decreases.

As a metal contained in the second barrier metal film **A5,** a refractory metal is preferably used. Thus, in the process step of forming a wire of an upper layer after formation of the second copper wire **14,** even when heat of about 400 °C is applied, the second barrier metal film **A5** does not degrade due to the heat treatment. Therefore, a highly reliable semiconductor device can be achieved.

When the second barrier metal film **A5** has a small thickness, the second barrier metal film **A5** does not necessarily have conductivity. However, it is preferable that the second barrier metal film **A5** has conductivity. Hereinafter, the second barrier metal film **A5** having conductivity will be specifically described.

As a metal forming the barrier metal film **A5,** titanium (Ti), zirconium (Zr), hafnium (Hf), tantalum (Ta), niobium (Nb), tungsten (W), vanadium (V), molybdenum (Mo), ruthenium (Ru), osmium (Os), rhodium (Rh), iridium (Ir), palladium (Pd) or platinum (Pt) is preferably used.

It is more preferable that as a metal forming the second barrier metal film **A5,** vanadium (V), molybdenum (Mo), ruthenium (Ru), osmium (Os), rhodium (Ru), iridium (Ir), palladium (Pd), platinum (Pt) or the like is used. Thus, when the metal is oxidized, conductivity is not largely lost (or a resistivity is small), so that the second barrier metal film **A5** having a low resistance can be formed.

As has been described, in the semiconductor device according to the fifth embodiment of the present invention, the oxygen concentration in the second barrier metal film **A5** of a film containing oxygen as a component element continuously varies in the direction from a surface of the second barrier metal film **A5** which is in contact with an insulation film (i.e., the second insulation film **6,** the third insulation film 7 and the fourth insulation film **8)** to a surface of the second barrier metal film **A5** which is in contact with the second copper wire **14.** Thus, the second barrier metal film **A5** does not have an interface at which a composition is remarkably changed, so that the strength of the second barrier metal film **A5** itself can be largely improved. Therefore, a highly reliable semiconductor device including a multi-layer wire with a low resistance and excellent adhesion can be achieved. Furthermore, by increasing the oxygen concentration in the vicinity of the interface between the second barrier metal film **A5** and the insulation film (i.e., each of the second insulation film 6, the third insulation film 7 and the fourth insulation film **8),** adhesion between the second barrier metal film **A5** and the insulation film (i.e., the second insulation film 6, the third insulation film 7 and the fourth insulation film **8)** can be improved. Also, by reducing the oxygen concentration in the vicinity of the interface between the second barrier metal film **A5** and the second copper wire **14,** adhesion between the second barrier metal film **A5** and the second copper wire 14 can be improved.

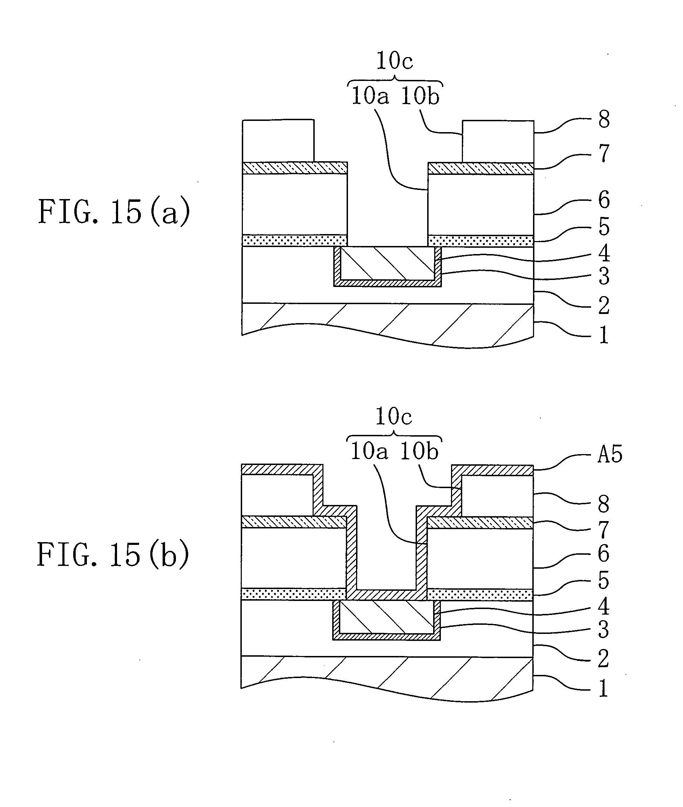

Next, a method for fabricating a semiconductor device according to the fifth embodiment of the present invention will be described with reference to FIG. 14 and FIGS. **15(a)** through **15(c).** Specifically, a method for fabricating the semiconductor device of FIG. 13 according to the fifth embodiment of the present invention will be hereinafter described.

First, in the same manner as shown in FIG. **2(a)** in the first embodiment, a recess portion **10c** including a via hole **10a** and a wiring groove **10b** for dual damascene is formed as shown in FIG. **15(a).**

Next, as shown in FIG. **15(b),** a second barrier metal film **A5** is formed on the second insulation film 6, the third insulation film 7 and the fourth insulation film 8 so as to cover surfaces of the recess portion **10c.** In this case, the second barrier metal film **A5** is preferably formed by atomic layer deposition (ALD), chemical vapor deposition (CVD), physical vapor deposition (PVD) or like film formation method.

Hereinafter, a method for forming the second barrier metal **A5,** for example, in the case where the second barrier metal film **A5** has an oxygen concentration which continuously varies from ruthenium (Ru) to ruthenium oxide (RuO₂) will be described in detail.

A known atomic layer deposition technique (Journal of The Electrochemical Society, 151, G109-G112 (2004)) is used to form the second barrier metal film **A5.** Conditions for film formation in this case are as follows. For example, Ru(EtCp)₂ (bis(ethylcyclopentadienyl)ruthenium) gas is used as a source gas of ruthenium (Ru). Where the source gas is heated to 80 °C, the source gas is diluted with Ar gas of 50 mL/min (standard temperature and pressure, dry) for use. The temperature of a substrate is 250 °C and the degree of vacuum is 4.56 × 10² Pa. As oxygen gas, a gas obtained by mixing Ar gas of 100mL/min (standard temperature and pressure, dry) to oxygen gas of 70 mL/min (standard temperature and pressure, dry) is used. An arbitrary composition in the range from metal ruthenium to ruthenium oxide can be obtained by changing a pulse time used for supplying Ru(EtCp)₂ gas. The range of the pulse time is from 1 second to 10 seconds. After Ru(EtCp)₂ gas is supplied and then purged for a certain period of time, oxygen gas is supplied. When the supply of oxygen gas is stopped, purge is performed for a certain period of time. Thus, a film of a single atomic layer of Ru and O can be grown. This series of steps is assumed to be a cycle. When metal ruthenium is grown, oxygen gas is not supplied.

For example, with the pulse time for supplying Ru(EtCp)₂ continuously changed from 2 seconds to 10 seconds, the second barrier metal film **A5** is formed on the second insulation film 6, the third insulation film 7 and the fourth insulation film **9** so as to have a thickness of 10 nm. In the second barrier metal film **A5** formed in the above-described manner, a distribution of atomic concentration in the film thickness direction is as shown in FIG. **14.** In this manner, the composition of the second barrier metal film **A5** can be controlled in a simple manner by changing a pulse time.

Next, a copper film is formed over the second barrier metal film **A5** as well as inside the recess portion **10c** by copper electroplating so as to fill the recess portion **10c** and then parts of the copper film and the second barrier metal film **A5** located on the fourth insulation film **8,** except for parts thereof located inside the recess portion **10c,** are removed by CMP, thereby forming a second copper wire **14** and a via plug which is part of the second copper wire **14.** Thus, a semiconductor device having the structure of FIG. **13** can be obtained. A multi-layer wire can be formed by repeating the process steps from film formation of the dielectric barrier film 5 to CMP.

As has been described, according to the method for fabricating a semiconductor device according to the fifth embodiment of the present invention, the second barrier metal film **A5** of which an oxygen element concentration continuously varies in the film thickness direction can be formed in a simple manner. Moreover, the same effects as those of the semiconductor device of the fifth embodiment can be achieved. Specifically, in the second barrier metal film **A5** of a film containing oxygen as a component element, the concentration of oxygen continuously varies in the direction from a surface of the second barrier metal film **A5** which is in contact with an insulation film (i.e., each of the second insulation film **6,** the third insulation film 7 and the fourth insulation film **8)** to a surface of the second barrier metal film **A5** which is in contact with the second copper wire **14.** Thus, the second barrier metal film **A5** does not have an interface at which a composition is remarkably changed, so that the strength of the second barrier metal film **A5** itself can be largely improved. Therefore, a highly reliable semiconductor device including a multi-layer wire with a low resistance and excellent adhesion can be achieved. Furthermore, by increasing the oxygen concentration in the vicinity of the interface between the second barrier metal film **A5** and the insulation film (i.e., each of the second insulation film **6,** the third insulation film **7** and the fourth insulation film **8),** adhesion between the second barrier metal film **A5** and the insulation film (i.e., the second insulation film **6,** the third insulation film **7** and the fourth insulation film **8)** can be improved. Also, by reducing the oxygen concentration in the vicinity of the interface between the second barrier metal film **A5** and the second copper wire **14,** adhesion between the second barrier metal film **A5** and the second copper wire **14** can be improved.

In each of the above-described first through fifth embodiments, the case where a dual damascene structure is adopted has been described. However, needless to say, even when a single damascene structure is adopted, the same effects as those in the case of adoption of a dual damascene structure can be achieved. When a single damascene structure is adopted, a wire and a via plug are formed in separate steps. In such a case, the wire and the via plug are included in a buried wire, i.e., the second copper wire **14** of each of the first through fifth embodiments.

### INDUSTRIAL APPLICABILITY

As has been described, the present invention is useful to a semiconductor device including a barrier metal film with a low resistance and excellent adhesion and a method for fabricating the semiconductor device.

## Claims

1. A semiconductor device comprising:
an insulation film formed on a substrate;
a buried wire formed in the insulation film; and
a barrier metal film formed between the insulation film and the buried wire,
wherein the barrier metal film is formed of a metal oxide film, a transition layer and a metal film stacked in this order in the direction from a side of the barrier metal film at which the insulation film exists to a side thereof at which the buried wire exists, and
wherein the transition layer is formed of a single atomic layer having substantially an intermediate composition between respective compositions of the metal oxide film and the metal film.

2. The semiconductor device of claim 1, wherein a metal forming the metal oxide film and a metal forming the metal film are different elements.

3. The semiconductor device of claim 1, wherein a metal forming the metal oxide film and a metal forming the metal film are the same element.

4. A semiconductor device comprising:
an insulation film formed on a substrate;
a buried wire formed in the insulation film; and
a barrier metal film formed between the insulation film and the buried wire,
wherein the barrier metal film is formed of a metal oxide film, a transition layer and a metal film stacked in this order in the direction from a side of the barrier metal film at which the insulation film exists to a side thereof at which the buried wire exists, and
wherein the transition layer is formed of a plurality of atomic layers having substantially an intermediate composition between respective compositions of the metal oxide film and the metal film.

5. The semiconductor device of claim 4, wherein a metal forming the metal oxide film and a metal forming the metal film are different elements.

6. The semiconductor device of claim 4, wherein a metal forming the metal oxide film and a metal forming the metal film are the same element.

7. A semiconductor device comprising:
an insulation film formed on a substrate;
a buried wire formed in the insulation film; and
a barrier metal film formed between the insulation film and the buried wire,
wherein the barrier metal film is formed of a transition layer and a metal film stacked in this order in the direction from a side of the barrier metal film at which the insulation film exists to a side thereof at which the buried wire exists, and
wherein the transition layer is formed of a single atomic layer including a metal oxide and a metal forming the metal film and having substantially an intermediate composition between respective compositions of the metal oxide and the metal film.

8. The semiconductor device of claim 7, wherein a metal forming the metal oxide and a metal forming the metal film are different elements.

9. The semiconductor device of claim 7, wherein a metal forming the metal oxide and a metal forming the metal film are the same element.

10. A semiconductor device comprising:
an insulation film formed on a substrate;
a buried wire formed in the insulation film; and
a barrier metal film formed between the insulation film and the buried wire,
wherein the barrier metal film is formed of a transition layer and a metal film stacked in this order in the direction from a side of the barrier metal film at which the insulation film exists to a side thereof at which the buried wire exists, and
wherein the transition layer is formed of a plurality of atomic layers including metal oxide and a metal forming the metal film and having substantially an intermediate composition between respective compositions of the metal oxide and the metal film.

11. The semiconductor device of claim 10, wherein a metal forming the metal oxide and a metal forming the metal film are different elements.

12. The semiconductor device of claim 10, wherein a metal forming the metal oxide and a metal forming the metal film are the same element.

13. A semiconductor device comprising:
an insulation film formed on a substrate;
a buried wire formed in the insulation film; and
a barrier metal film formed between the insulation film and the buried wire,
wherein the barrier metal film contains oxygen as a component element, and
wherein a concentration of oxygen contained in the barrier metal film continuously varies in a film thickness direction of the barrier metal film.

14. A method for fabricating a semiconductor device, the method comprising the steps of:
forming a recess portion in an insulation film provided on a substrate;
forming a barrier metal film including a metal oxide film, a transition layer and a metal film stacked in this order so that the barrier metal film covers surfaces of the recess portion; and
forming a buried wire on the barrier metal film so that the recess portion is filled,
wherein the step of forming the barrier metal film includes the step of performing a single cycle of deposition by atomic layer deposition, thereby forming the transition layer of a single atomic layer having substantially an intermediate composition between respective compositions of the metal oxide film and the metal film.

15. The method of claim 14, wherein a metal forming the metal oxide film and a metal forming the metal film are different elements.

16. The method of claim 14, wherein a metal forming the metal oxide film and a metal forming the metal film are the same element.

17. A method for fabricating a semiconductor device, the method comprising the steps of:
forming a recess portion in an insulation film provided on a substrate;
forming a barrier metal film including a metal oxide film, a transition layer and a metal film stacked in this order so that the barrier metal film covers surfaces of the recess portion; and
forming a buried wire on the barrier metal film so that the recess portion is filled,
wherein the step of forming the barrier metal film includes the step of performing a plurality of cycles of deposition by atomic layer deposition, thereby forming the transition layer including a plurality of atomic layers having substantially an intermediate composition between respective compositions of the metal oxide film and the metal film.

18. The method of claim 17, wherein a metal forming the metal oxide film and a metal forming the metal film are different elements.

19. The method of claim 17, wherein a metal forming the metal oxide film and a metal forming the metal film are the same element.

20. A method for fabricating a semiconductor device, the method comprising the steps of:
forming a recess portion in an insulation film provided on a substrate;
forming a barrier metal film including a transition layer and a metal film stacked in this order so that the barrier metal film covers surfaces of the recess portion; and
forming a buried wire on the barrier metal film so that the recess portion is filled,
wherein the step of forming the barrier metal film includes the step of performing a single cycle of deposition by atomic layer deposition, thereby forming the transition layer made of a single atomic layer including a metal oxide and a metal forming the metal film and having substantially an intermediate composition between respective compositions of the metal oxide and the metal film.

21. The method of claim 20, wherein a metal forming the metal oxide and a metal forming the metal film are different elements.

22. The method of claim 20, wherein a metal forming the metal oxide and a metal forming the metal film are the same element.

23. A method for fabricating a semiconductor device, the method comprising the steps of:
forming a recess portion in an insulation film provided on a substrate;
forming a barrier metal film including a transition layer and a metal film stacked in this order so that the barrier metal film covers surfaces of the recess portion; and
forming a buried wire on the barrier metal film so that the recess portion is filled,
wherein the step of forming the barrier metal film includes the step of performing a plurality of cycles of deposition by atomic layer deposition, thereby forming the transition layer including a plurality of atomic layers made of a metal forming a metal oxide and the metal film and having an intermediate composition between respective compositions of the metal oxide and the metal film.

24. The method of claim 23, wherein a metal forming the metal oxide and a metal forming the metal film are different elements.

25. The method of claim 23, wherein a metal forming the metal oxide and a metal forming the metal film are the same element.

26. A method for fabricating a semiconductor device, the method comprising the steps of:
forming a recess portion in an insulation film provided on a substrate;
forming a barrier metal film containing oxygen as a component element so that the barrier metal film covers surfaces of the recess portion; and
forming a buried wire on the barrier metal film so that the recess portion is filled,
wherein the step of forming the barrier metal film includes the step of forming the barrier metal such that a concentration of oxygen contained in the barrier metal film continuously varies in a film thickness direction of the barrier metal film.
